(19) **Europäisches Patentamt**
European Patent Office
Office européen des brevets

(11) **EP 1 921 179 B1**

(12) **EUROPÄISCHE PATENTSCHRIFT**

(45) Veröffentlichungstag und Bekanntmachung des Hinweises auf die Patenterteilung:
**11.01.2012 Patentblatt 2012/02**

(51) Int Cl.:
*C23C 16/515* (2006.01)    *C23C 16/455* (2006.01)

(21) Anmeldenummer: **07021685.8**

(22) Anmeldetag: **08.11.2007**

(54) **Beschichtungsanlage und Verfahren zur Beschichtung**

Coating facility and method for coating

Installation de revêtement et procédé de revêtement

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **10.11.2006 DE 102006053365**
**09.08.2007 DE 102007037527**

(43) Veröffentlichungstag der Anmeldung:
**14.05.2008 Patentblatt 2008/20**

(73) Patentinhaber: **Schott AG**
**55122 Mainz (DE)**

(72) Erfinder:
• **Moelle, Christoph, Dr.**
**55131 Mainz (DE)**
• **Bewig, Lars, Dr.**
**37581 Bad Gandersheim (DE)**
• **Küpper, Thomas**
**37581 Bad Gandersheim (DE)**

(74) Vertreter: **Herden, Andreas F.**
**Blumbach - Zinngrebe**
**PatentConsult**
**Patentanwälte**
**Alexandrastrasse 5**
**65187 Wiesbaden (DE)**

(56) Entgegenhaltungen:
| | |
|---|---|
| EP-A- 0 519 215 | EP-A- 1 630 848 |
| WO-A-03/062490 | DE-A1- 10 258 678 |
| US-A- 4 761 269 | US-A- 5 146 869 |
| US-A- 6 025 013 | |

EP 1 921 179 B1

**Beschreibung**

Die Erfindung betrifft eine Beschichtungsanlage, insbesondere eine CVD-Beschichtungsanlage und ein Verfahren zum Beschichten sowie beschichtete Gegenstände.

Der Produktveredelung durch Auftrag von Mehrschichtsystemen kommt zunehmende Bedeutung zu. Beispielsweise sind optische Bauteile heute nicht mehr ohne Antireflex-, farbgebende oder generell Phasenfront-beeinflussende Schichtsysteme denkbar.

Aber auch im Alltag können Schichtsysteme von wesentlichem Einfluss für den Wert eines Produktes sein. Barriereschichten können in Kunststoffgefäßen die Permeation unerwünschter Stoffe vermindern und so die Qualität sowie Haltbarkeit der darin aufbewahrten Substanzen verbessern. Diesbezüglich stehen medizinische Wirkstoffe oder auch Nahrungsmittel im Vordergrund.

Die Qualität der aufgetragenen Schichtsysteme sowie deren wirtschaftliche Herstellbarkeit ist dabei von ausschlaggebender Bedeutung für die jeweiligen Einsatzgebiete.

Für optische wirksame Schichten, welche das Reflexions-und/oder spektrale Absorptionsverhalten beeinflussen können, sind dabei abrupte, möglichst steile Brechungsindexwechsel der aufgetragenen Schichten wichtig, um an diesen Brechungsindexänderungen lokal möglichst gut definiert Einfluß auf hindurchtretende Phasenfronten eines Lichtwellenfeldes nehmen zu können.

Zusätzlich zu diesen möglichst steilen Brechungsindexänderungen ist aber auch Dicke sowie Zusammensetzung und insbesondere die Dichte der aufgetragenen Schichten wesentlich, da diese im Mehrschichtsystem den wirksamen optischen Weglängenunterschied definieren und direkten Einfluß auf die Eigenschaften des erhaltenen Endproduktes haben.

Darüber hinaus ist es nötig, diese Parameter über einen grösseren flächigen Bereich konstant zu halten, um nicht spektrale Abweichungen in Form lokaler flächiger Fehlstellen zu erzeugen.

Folglich ist die Reinheit, definierte Zufuhr von schichterzeugenden Sustanzen und deren kontrollierte Reaktion ein wichtiger Schlüssel für die zu erhaltende Produktqualität und auch für die Wirtschaftlichkeit der Beschichtungsverfahren.

Aus der EP 0 519 215 B1 ist eine Anlage zum Beschichten von kalottenförmigen Substraten mittels plasmainduzierter Dampfphasenabscheidung bekannt. Mit der Anlage können mehrere Substrate gleichzeitig beschichtet werden, wobei eine Gasverteilungseinrichtung vorgesehen ist, mit der drei Gase miteinander vermischt werden können. Für die drei Gase ist jeweils eine eigene Gasleitung vorgesehen, die in eine gemeinsame in einen Gaseinlasskanal mündende Gasleitung zusammengeführt sind. Ein Gas, welches ständig beigemischt wird, strömt ständig durch die Gasleitung, während die beiden anderen Gase mit schnell schaltenden Ventilen zugemischt werden. Weiterhin sind mit Ventilen versehene Bypass-Leitungen vorgesehen, um das jeweils nicht benötigte Gas über die entsprechende Bypass-Leitung zur Pumpe zu führen und so den Gasmassenfluss konstant zu halten. Ein weiterer Nachteil bekannter Vorrichtungen und Verfahren ist, daß Verunreinigungen in den Schichten durch die Anreicherung von Reaktionsprodukten im Plasma entstehen können.

Bei der Abscheidung von Wechselschichten, wie insbesondere von Vielfach-Interferenzschichtsystemen mittels plasmaunterstützter chemischer Dampfphasenabscheidung ist es außerdem für die Qualität, beziehungsweise die optischen Eigenschaften des Schichtsystems äußerst vorteilhaft, wenn die Grenzflächen zwischen den einzelnen Lagen des Schichtsystems möglichst scharf und gut definiert sind.

Nachteilig ist es dabei, wenn nach einem Gaswechsel auf eine Atmosphäre mit einem anderen Precorsor im Beschichtungsvolumen noch Reste des vorherigen Precursors vorhanden sind. In diesem Fall scheiden sich Reaktionsprodukte des vorherigen Precursors in der nachfolgenden Lage ab. So kann dann beispielsweise bei einem Wechselschichtsystem mit abwechselnden $SiO_2$-$TiO_2$-Lagen Titanoxid in den Siliziumoxid-Lagen vorhanden sein und umgekehrt. Da gerade hochwirksame Interferenz-Wechselschichtsysteme eine Vielzahl von Lagen, vorzugsweise mehr als 30 Lagen aufweisen, müssen viele aufeinanderfolgende Gaswechsel durchgerührt werden. Diese Gaswechsel sollten für einen ökonomischen Prozess möglichst schnell, zur Erzielung einer hohen Güte des Schichtsystems andererseits möglichst vermischungsfrei durchgeführt werden können.

Diese Aufgabe wird auf überraschend einfache Weise bereits mit einer Vorrichtung gemäß Anspruch 1 und einem Verfahren gemäß Anspruch 20 gelöst, wie diese in denjeweiligen unabhängigen Ansprüchen angegeben sind. Vorteilhafte Ausgestaltungen und Weiterbildungen der Erfindung sind in den abhängigen Ansprüchen angegeben.

Demgemäß ist erfindungsgemäß eine Beschichtungsanlage zum Beschichten von Gegenständen mit Wechselschichten, vorzugsweise zum gleichzeitigen Beschichten mehrerer Gegenstände mit Wechselschichten vorgesehen, die zumindest eine Reaktionskammer aufweist, in welcher zu beschichtende Gegenstände anordnbar sind, oder eine Einrichtung, um mit einem zu beschichtenden Gegenstand eine Reaktionskammer zu bilden. Eine Zuführung ist vorgesehen, mit welcher für bei dem Beschichten verwendete Prozessgase, insbesondere Precursorgase durch eine Gaswechseleinrichtung in die Reaktionskammer einleitbar sind. Dabei umfasst die Gaswechseleinrichtung zumindest einen Gasmischpunkt, in welchen zwei mit Ventilen versehene Zuleitungen für verschiedene Precursor-Gase, sowie zumindest eine Zuleitung für ein weiteres Gas, um dieses im Gasmischpunkt mit einem durch eines der Ventile eingeleiteten Gase zur Erzeugung unterschiedlicher Prozessgas-Gemische zu mischen, sowie eine Ableitung zur Reaktionskammer münden. Die Zuleitung für ein weiteres Gas und die Ableitung zur Reaktionskammer sind in der Verbindung zwischen den beiden Ventilen angeschlossen. Zu jeder der Zuleitungen für verschiedene Precursor-Gase ist außerdem jeweils eine mit einer Pumpeinrichtung verbundene Bypass-Leitung vorgesehen, wobei in die Bypass-Leitungen jeweils ein weiteres Ventil geschaltet ist. Außerdem ist eine Steuereinrichtung vorgesehen, welche für einen Wechsel des Prozessgasgemischs die Ventile in den Bypass-Leitungen und die Ventile der Zuleitungen für verschiedene PrecursorGase so steuert, daß gleichzeitig das Ventil in der Zuleitung eines Precursorgases geschlossen, und das Ventil in der Bypass-Leitung für dieses Precursorgas geöffnet wird, wobei nach dem Schließen des Ventils in der Zuleitung eines Precursorgases umgekehrt das Ventil in der Zuleitung des anderen Precursorgases geöffnet und das Ventil in der Bypass-Leitung für dieses Precursorgas gleichzeitig geschlossen wird. Zwischen dem Schließen des Ventils in der Zuleitung für das eine Precursorgas und dem Öffnen des anderen Ventils in der Zuleitung für das weitere Precursorgas kann eine Pause vorhanden sein. Diese wird möglichst kurz gehalten, oder sogar ganz weggelassen. In letzterem Fall schalten die vier oben genannten Ventile gleichzeitig.

Selbst bei direkt aufeinanderfolgenden Gaspulsen mit unterschiedlicher Zusammensetzung zur Abscheidung von Wechselschichtsystemen ist es besonders vorteilhaft, beim Wechsel des Gasgemisches eine Pause zwischen den jeweils für die Abscheidung der einzelnen Lagen eingesetzten Pulsserien von Mikrowellenpulsen einzuhalten. Diese Pause zwischen zwei Pulsserien sorgt dafür, daß keine Plasmapulse erzeugt werden, während der Prozessgaswechsel stattfindet. Würde die Quelle für elektromagnetische Energie weiterbetrieben, während das Prozessgas ausgetauscht wird, käme es dann zu einer Abscheidung eines Mischoxids mit Metalloxiden beider Prozessgasgemische. Zwar wäre eine solche Mischoxid-Lage äußerst dünn, da der Prozessgaswechsel im allgemeinen während der Dauer nur eines oder einiger Plasmapulse stattfindet, allerdings führt dies überraschend dennoch zu einer weniger gut definierten Grenzfläche zwischen den Lagen, welche die optischen Eigenschaften merklich beeinflusst. Umgekehrt kann mit einer Einhaltung einer Pause zwischen den Pulsserien, welche mit der Ventilsteuerung synchronisiert ist, eine merklich Verbesserung der Güte optischer Wechselschichtsysteme erreicht werden. Dazu ist erfindungsgemäß eine Beschichtungsanlage und ein Verfahren zum Beschichten von Gegenständen mit Wechselschichten vorgesehen, wobei die Anlage zumindest eine Reaktionskammer, in welcher zu beschichtende Gegenstände anordenbar sind, oder eine Einrichtung, um mit einem zu beschichtenden Gegenstand eine Reaktionskammer zu bilden umfasst. Außerdem ist eine gepulst betreibbare Quelle für elektromagnetische Energie vorgesehen, um im Reaktor ein gepulstes Plasma zu zünden. Mittels einer Zuführung werden die bei dem Beschichten verwendete Prozessgase, insbesondere Precursorgase durch eine Gaswechseleinrichtung der Beschichtungsanlage in die Reaktionskammer eingeleitet. Die Gaswechseleinrichtung umfasst zumindest einen Gasmischpunkt, in welchen zumindest zwei mit Ventilen versehene Zuleitungen für verschiedene Precursor-Gase, sowie zumindest eine Zuleitung für ein weiteres Gas, um dieses im Gasmischpunkt mit einem durch eines der Ventile eingeleiteten Gase zur Erzeugung unterschiedlicher Prozessgas-Gemische zu mischen, sowie eine Ableitung zur Reaktionskammer münden. In vorteilhafter Ausgestaltung ist die Zuleitung für ein weiteres Gas und die Ableitung zur Reaktionskammer in der Verbindung zwischen den beiden Ventilen angeschlossen wobei zu jeder der Zuleitungen für verschiedene Precursor-Gase jeweils eine mit einer Pumpeinrichtung verbundene Bypass-Leitung vorgesehen ist, wobei in die Bypass-Leitungen jeweils ein weiteres Ventil geschaltet ist.

Außerdem ist eine Steuereinrichtung für die Ventile und die Quelle vorgesehen, welche für einen Wechsel des Prozessgasgemischs die Ventile in den Bypass-Leitungen und die Ventile der Zuleitungen für verschiedene Precursor-Gase so steuert, daß gleichzeitig das Ventil in der Zuleitung eines Precursorgases geschlossen, und das Ventil in der Bypass-Leitung für dieses Precursorgas geöffnet wird, und umgekehrt das Ventil in der Zuleitung des anderen Precursorgases geöffnet und das Ventil in der Bypass-Leitung für dieses Precursorgas gleichzeitig geschlossen wird. Die Steuereinrichtung stellt außerdem den Zeitpunkt des Beginns einer Pulsserie zur Abscheidung einer Lage des Wechselschichtsystems in Abhängigkeit von der Schaltzeit der Ventile ein, wobei die Steuereinrichtung zwischen den Pulsserien eine Pause mit einer Dauer von mindestens $0{,}8 \times |t_{Vorlauf} - t_{Nachlauf}|$ und höchstens $5 \times |t_{Vorlaut} - t_{Nachlauf}|$ einstellt, wobei $t_{Vorlauf}$ die Zeitdauer bezeichnet, welche das Gas benötigt, um vom Gasmischpunkt bis zur Reaktionskammer zu gelangen und wobei $t_{Nachlauf}$ die Zeitdauer bezeichnet, welche für die Entleerung des vorher in der Reaktionskammer befindlichen Prozessgasgemisches benötigt wird. Diese Ausführungsform der Erfindung ist nicht notwendigerweise auf die spezielle Anordnung der Ventile mit Bypass-Leitungen beschränkt. Wesentlich ist hier, daß die Laufzeit der von einem Gasmischpunkt ausgehenden, durch eine Zuleitung in den Reaktor geleiteten Gaspulse und die Entleerungszeit des Reaktors bei der Ansteuerung der Quelle berücksichtigt und entsprechende, wie oben angegebene Pausen zwischen Pulsserien eingestellt werden.

Um den Beginn einer Pulsserie mit dem Einfüllen des jeweiligen für die Abscheidung einer Lage vorgesehenen Prozessgasgemisch zu synchronisieren, ist es außerdem von Vorteil, wenn die Quelle mittels der Steuereinrichtung so gesteuert wird, daß eine Pulsserie zur Abscheidung einer Lage des Wechselschichtsystems jeweils zu einem Zeitpunkt gestartet wird, der um eine Dauer T zum Schaltzeitpunkt der zugeordneten Ventile für das jeweilige Prozessgasgemisch in der Zuleitung zur Abscheidung einer Lage des Wechselschichtsystems verzögert ist. Vorzugsweise liegt die Dauer T in einem Bereich von zumindest 0,8 × $t_{Vorlauf}$ bis -in Abhängigkeit der Länge der Zuleitung- höchstens 500 × $t_{Vorlauf}$, vorzugsweise bis höchstens 50 × $t_{Vorlauf}$ beträgt. Als Einrichtung, um mit dem zu beschichtenden Gegenstand eine Reaktionskammer zu bilden, kommt insbesondere eine Abdichteinrichtung in Frage, mit welcher ein Bereich der Oberfläche des zu beschichtenden Gegenstands von der Umgebung abgetrennt werden kann, so daß der so abgetrennte Bereich, der von der Oberfläche des Gegenstands begrenzt wird, als Reaktionskammer dienen kann. Dieser Bereich kann evakuiert, das Prozessgas eingelassen und ein Plasma in diesem Bereich gezündet werden. Ein Beispiel hierfür ist eine Innenbeschichtung von Kalotten, wie etwa von Scheinwerferkalotten. Hierbei kann die Innenseite der Kalotte durch Abdichtung an deren Rand von der Umgebung abgetrennt werden, wobei der so gebildete, von der Innenseite der Kalotte begrenzte Bereich dann die Reaktionskammer bildet.

Insbesondere bei CVD-Verfahren, umfassend PECVD und PICVD-Verfahren, soll durch die Erfindung somit die Reinheit abgeschiedener Schichten verbessert und eine möglichst verunreinigungsfreie, möglichst zeitlich und mengenmäßig präzise Zufuhr von Prozessgasen für die angestrebten Schichtsysteme geschaffen werden.

Diese weitere Aufgabe wird erfindungsgemäß dadurch gelöst, daß die Steuereinrichtung die Quelle so steuert, daß diese im Betrieb Pulse elektromagnetischer Energie abgibt, so daß im Reaktor ein gepulstes Plasma erzeugt wird.

Dabei wurde eine einfache lineare Gesetzmäßigkeit für die Untergrenze der Pulspause gefunden. Besonders bevorzugt wird die Pause zwischen den Plasmapulse mittels der Steuereinrichtung so eingestellt, daß sie länger ist als P[ms]=2,5 + 0,05*V, vorzugsweise P[ms]=2,5 + 0,055*V, wobei P[ms] die Pause in Millisekunden und V das Beschichtungsvolumen in der Reaktionskammer in Millilitern bezeichnen.

Bei kleinen Reaktorvolumina steigt die Untergrenze der Pulspausen für eine optimale Schichtabscheidung noch etwas schneller mit steigendem Reaktorvolumen an. Die Untergrenze kann dabei in bevorzugter Weiterbildung auch durch folgende Beziehung ausgedrückt werden:

$$P[ms] = V \cdot [(1/6) \cdot exp(-V/300) + (1/20)].$$

Diese Kurve schneidet die oben angegebene Gerade P[ms]=2,5 + 0,05*V und ergibt bei sehr kleinen Reaktorvolumina kleinere Werte der Pulspause. In diesem Bereich kann die Pulspause wieder durch P[ms]=2,5 + 0,05*V, vorzugsweise P[ms]=2,5 + 0,055*V als Untergrenze gewählt werden, damit die Pulspause nicht zu kurz wird. Mit anderen Worten kann gemäß dieser Weiterbildung der Erfindung die Länge der Pulspause durch eine Untergrenze begrenzt werden, welche das Maximum der Beziehungen P[ms]=V·[(1/6)·exp(-V/300) + (1/20)] und P[ms]=2,5 + 0,05*V darstellt:

$$P[ms] = max( 2,5 + 0,05*V, V \cdot [(1/6) \cdot exp(-V/300) + (1/20)]).$$

Im Speziellen ist die Steuereinrichtung also eingerichtet, die Quelle so zu steuern, daß die Quelle zeitlich beabstandete Pulse abgibt, welche Plasmapulse mit einer Dauer der Länge D und einer Pause der Länge P zwischen den Pulsen erzeugen, wobei für die Plasmapulse gilt, daß die Pulspause P in Millisekunden zwischen zwei zeitlich benachbarten Pulsen länger ist, als die oben angegebene Beziehung.

Das mittels dieser Beschichtungsanlage durchführbare Beschichtungsverfahren mit den oben angegebenen Pausen zwischen den einzelnen Plasmapulsen ermöglicht einen vollständigen Gasaustausch im Reaktorvolumen während der Pulspause. Im allgemeinen entspricht die Länge der Pulse elektromagnetischer Energie im wesentlichen der Länge der damit erzeugten Plasmapulse, so daß die Steuereinrichtung in diesen Fällen die Quelle so steuern kann, daß die Quelle Pulse elektromagnetischer Energie abgibt, welche gemäß der oben angegebenen Beziehung zeitlich beabstandet sind. Ergeben sich andererseits Verzögerungen bei der Zündung des Plasmas nach dem Einschalten, beziehungsweise dem Beginn des elektromagnetischen Pulses, kann diese Verzögerungszeit entsprechend berücksichtigt werden. In diesem Fall wird die Steuereinrichtung die Quelle so steuern, daß die Pausen zwischen elektromagnetischen Pulsen entsprechend kürzer sind, so daß sich die gewünschte Pause zwischen den Plasmapulsen ergibt. Da die oben angegebene Beziehung eine Untergrenze darstellt, kann aber im allgemeinen diese Beziehung auch für die elektromagnetischen Pulse verwendet werden. Die Anpassung der Pulspause an das Reaktorvolumen hat noch einen weiteren besonderen Vorteil. Wird das Reaktorvolumen nur teilentleert, bevor der nächste Plasmapuls gezündet wird, kommt es beim nächsten Plasmapuls zu einer nicht vollständigen Beschichtung, verglichen zu einem Plasmapuls nach vollständigem Gasaustausch, da im ersten Fall eine geringere Konzentration von Precursor-Gas im Reaktorvolumen vorhanden ist. Die Anpassung der Mindest-Pulspause an das Reaktorvolumen führt also dazu, daß eine stets reproduzierbare Menge an Schichtmaterial abgeschieden wird. Damit kann eine besonders genaue Einstellung der Schichtdicke der einzelnen Lagen erfolgen. Insgesamt wird damit bei optischen Interferenzschichtsystemen eine besonders hohe Güte erzielt.

Als Quelle wird eine gepulst betreibbare Mikrowellen-Hochfrequenz- oder Radiofrequenz-Quelle bevorzugt. Beispielsweise sind Mikrowellen mit einer Frequenz von 2,45 GHz, also der gleichen Frequenz, wie sie auch verbreitet in Haushalts-Mikrowellengeräten verwendet wird, geeignet.

Um die Lagen der Beschichtung abzuscheiden, kann insbesondere elektromagnetische Energie in den Beschichtungsbereich geleitet werden, so daß ein Plasma gezündet wird. Die sich im Plasma des Prozessgas-Gemischs bildenden Reaktionsprodukte scheiden sich dabei auf der Oberfläche des zu beschichtenden Gegenstands ab.

Ein Precursor-Gas ist im Sinne der Erfindung insbesondere eine Verbindung eines schichtbildenden Elements. Insbesondere kommen hier verschiedene Metall- oder Halbleiterverbindungen zum Einsatz, wie Siliziumverbindungen, beispielsweise HMDSO (Hexamethyldisiloxan) oder Verbindungen von Metallen, deren Oxide hochbrechende Schichten bilden. Genannt seien hier etwa Titanchlorid oder Niobchlorid zur Abscheidung von Titanoxid-, beziehungsweise Nioboxid-Lagen. Diese können dann beispielsweise in Abwechslung mit Siliziumoxid-Lagen, die aus einem siliziumhaltigen Precursor abgeschieden werden, zu einem Interferenz-Wechselschichtsystem zusammengesetzt werden.

Als weiteres Gas, welches mit dem oder den Precursor-Gasen im Mischpunkt gemischt wird, kann insbesondere Sauerstoff oder ein Gasgemisch mit Sauerstoff verwendet werden. Der Sauerstoff reagiert dann im Plasma mit den Precursoren oder deren Reaktionsprodukten, so daß Oxidschichten mit den in den Precursor-Gasen gebundenen Metallen abgeschieden werden.

Das entsprechende, mit der Beschichtungsanlage durchführbare Verfahren zum Beschichten von Gegenständen mit Wechselschichten, vorzugsweise zum gleichzeitigen Beschichten mehrerer Gegenstände mit Wechselschichten basiert darauf, daß in zumindest einer Reaktionskammer ein zu beschichtender Gegenstand angeordnet, oder eine Reaktionskammer mit einem zu beschichtenden Gegenstand gebildet wird, zumindest der Beschichtungsbereich der Reaktionskammer evakuiert, und nacheinander verschiedene Prozessgase in den Beschichtungsbereich geleitet und ein Plasma zur Abscheidung gezündet wird, wodurch ein Schichtsystem mit Lagen unterschiedlicher Zusammensetzung auf dem Gegenstand abgeschieden wird, wobei das Einleiten der Prozessgase in die Reaktionskammer mittels einer Gaswechseleinrichtung erfolgt, wobei die Gaswechseleinrichtung zumindest einen Gasmischpunkt umfasst, in welchen zwei mit Ventilen versehene Zuleitungen für verschiedene Precursor-Gase, sowie zumindest eine Zuleitung für ein weiteres Gas münden, wobei dieses weitere Gas im Gasmischpunkt mit jeweils einem der durch eines der Ventile eingeleiteten Gase gemischt wird und durch eine Ableitung zur Reaktionskammer abgeführt wird, wobei die Zuleitung für ein weiteres Gas und die Ableitung zur Reaktionskammer in der Verbindung zwischen den beiden Ventilen angeschlossen sind, und wobei zu jeder der Zuleitungen für verschiedene Precursor-Gase jeweils eine mit einer Pumpeinrichtung verbundene Bypass-Leitung vorgesehen ist, wobei in die Bypass-Leitungen jeweils ein weiteres Ventil geschaltet ist, und wobei das Prozessgasgemisch gewechselt wird, indem die Ventile in den Bypass-Leitungen und die Ventile der Zuleitungen für verschiedene Precursor-Gase so geschaltet werden, daß gleichzeitig das Ventil in der Zuleitung eines Precursorgases geschlossen, das Ventil in der BypassLeitung für dieses Precursorgas geöffnet und -eventuell nach einer Pause- umgekehrt das Ventil in der Zuleitung des anderen Precursorgases geöffnet und das Ventil in der Bypass-Leitung für dieses Precursorgas gleichzeitig geschlossen wird.

Mit der Erfindung werden auf diese Weise diskrete Gaspulse unterschiedlicher Gaszusammensetzungen erzeugt, die sich nicht vermischen. Insbesondere ist es von Vorteil, wenn dabei das Prozessgas im Beschichtungsvolumen in der Reaktorkammer für eine Lage vollständig oder zumindest im wesentlichen vollständig abgeführt werden kann, bevor der nächste Gaspuls mit einem anderen Prozessgas in die Reaktionskammer gelangt.

Durch das Umschalten der Ventile mit einer vorgegebenen Zeitverzögerung wird ein schneller Gaswechsel erzeugt, der beim Abscheiden von Wechselschichten, wie insbesondere von Interferenzschichtsystemen erstens für besonders reine Schichten und zweitens auch für scharfe Grenzflächen zwischen den einzelnen Lagen des Schichtsystems sorgt.

Die optimale Pulspause zwischen den Plasmapulsen kann auch vom beschichteten Substrat und der geforderten Schichtstruktur der Lagen abhängig sein und zur Erzielung optimaler Ergebnisse auch noch deutlich länger als die oben angegebene mimimale Dauer gewählt werden. Gemäß einer Weiterbildung der Erfindung wird dazu die Pause länger eingestellt als

$$P[ms] = 10 + 0{,}133 * V,$$

wobei P[ms] eine Zeitdauer in Millisekunden und V das Beschichtungsvolumen in der Reaktionskammer in Millilitern bezeichnen.

Andererseits ist eine zu große Pause zwischen den Plasmapulsen nachteilig für die Prozessgeschwindigkeit. Es hat sich gezeigt, daß die Pulspause im allgemeinen auf eine Zeitdauer kleiner als P[ms]=80 + 0,05*V eingestellt werden kann, um noch Lagen mit exakt definierter Schichtdicke zu erhalten. Allgemein können in den meisten Fällen dabei gute Beschichtungen bei Pulspausen erzielt werden, die kleiner als P[ms]=60 + 0,05*V, vorzugsweise kleiner als P[ms]=50 + 0,05*V sind.

Um beim Umschalten zwischen den verschiedenen Prozessgas-Gemischen möglichst geringe Auswirkungen des Schaltvorgangs auf die Gasströmung zu erhalten, ist vorgesehen, die Drücke in den Bypass-Leitungen an den Druck im Gasmischpunkt anzupassen. Dies kann insbesondere mit einer Regeleinrichtung geschehen. Eine möglichst genaue Druckanpassung ist wünschenswert, vorzugsweise sollte aber der Druck in den Bypass-Leitungen an den Druck im Gasmischpunkt auf eine Druckdifferenz angepasst werden, die kleiner als 20% des Drucks im Gasmischpunkt beträgt.

Besonders vorteilhaft für eine exakte Regelung der Gasflüsse ist es außerdem, eine Massenflußregelung vorzusehen, bei welcher am Regelungsort stark beschleunigte und damit im Wesentlichen von Rückwirkungen befreite Strömung auftritt. Dazu wird eine Regeleinrichtung vorgesehen, mit welcher ein Druckabfall entlang der Zuleitungen beim Einspeisen der Gase in den Gasmischpunkt um mehr als einen Faktor zwei aufrechterhalten oder eingestellt wird. Dieser Druckabfall kann an einem Nadelventil, etwa beispielsweise einem Nadelventil eines Massenflussreglers, oder auch beispielsweise an einer Blende erfolgen.

Gemäß einer weiteren alternativen oder zusätzlichen Ausführungsform der Erfindung ist eine Beschichtungsanlage zum Beschichten von Gegenständen mit Wechselschichten, vorzugsweise zum gleichzeitigen Beschichten mehrerer Gegenstände mit Wechselschichten vorgesehen, welche zumindest eine Reaktionskammer umfasst, in welcher zu beschichtende Gegenstände anordenbar sind, mit einer Zuführung für die bei dem Beschichten verwendeten Prozessgase, insbesondere für Precursorgase, welche durch eine Gaswechseleinrichtung in die Reaktionskammer einleitbar sind, wobei die Gaswechseleinrichtung zumindest einen Gasmischpunkt umfasst, wobei der Gasmischpunkt Bestandteil einer Mischpunktventil-Einheit ist, welche zwei Ventile umfasst, die an zwei Zuleitungen für verschiedene Precursor-Gase eines Prozessgasgemischs angeschlossen sind, sowie zumindest eine Zuleitung für ein weiteres Gas, um dieses im Gasmischpunkt mit einem durch eines der Ventile eingeleiteten Gase zu mischen, und eine Ableitung zur Reaktionskammer, wobei die Zuleitung für ein weiteres Gas und die Ableitung zur Reaktionskammer in der Verbindung zwischen den beiden Ventilen angeschlossen sind.

Mittels der Mischpunktventil-Einheit werden die Abstände zwischen den beiden Ventilen für die Precursor-Gase minimiert. Auf diese Weise wird eine verbesserte Abführung des Gases aus dem Mischpunkt in den Pulspausen, beziehungsweise beim Wechseln des Prozessgases zur Abscheidung eines Wechselschichtsystems erreicht. Um eine kompakte Mischpunktventil-Einheit zu schaffen, können die Ventilsitze der beiden Ventile insbesondere in einem gemeinsamen Ventilblock zusammengefasst sein.

Das mit dieser Ausführungsform der Erfindung durchführbare Verfahren zum Beschichten von Gegenständen mit Wechselschichten, vorzugsweise zum gleichzeitigen Beschichten mehrerer Gegenstände mit Wechselschichten basiert entsprechend darauf, zu beschichtende Gegenstände in zumindest einer Reaktionskammer anzuordnen, zumindest den Beschichtungsbereich der Reaktionskammer zu evakuieren und nacheinander verschiedene Prozessgase in den Beschichtungsbereich zu leiten und ein Plasma zur Abscheidung zu zünden, wodurch ein Schichtsystem mit Lagen unterschiedlicher Zusammensetzung auf dem Gegenstand abgeschieden wird, wobei das Einleiten der Prozessgase in die Reaktionskammer mittels einer Gaswechseleinrichtung erfolgt, und wobei die Gaswechseleinrichtung zumindest einen Gasmischpunkt umfasst, welcher als Mischpunktventil-Einheit, bevorzugt mit in einem ventilblock zusammengeschlossenen Ventilsitzen ausgebildet ist, welche zwei Ventile umfasst, die an zwei Zuleitungen für verschiedene Precursor-Gase eines Prozessgasgemischs angeschlossen sind, sowie zumindest eine Zuleitung für ein weiteres Gas, und eine Ableitung zur Reaktionskammer, wobei die Zuleitung für ein weiteres Gas und die Ableitung zur Reaktionskammer in der Verbindung zwischen den beiden Ventilen angeschlossen sind, wobei das weitere Gas im Gasmischpunkt mit einem durch eines der Ventile eingeleiteten Gase gemischt und der Reaktionskammer zugeführt wird, und zur Abscheidung einer Lage anderer Zusammensetzung durch Schalten der Ventile eine andere Gaszusammensetzung im Gasmischpunkt gemischt wird.

Mittels der Mischpunktventil-Einheit sollen Toträume in Form nur einseitig offener Volumina, die im Mischpunkt-Bereich durch Zuleitungen zu geschlossenen Ventilen gebildet werden, auf ein Minimum reduziert werden. Jedenfalls sollten diese Zuleitungsbereiche im Vergleich zur Ableitung zur Reaktionskammer möglichst kurz sein. In Weiterbildung der Erfindung ist dazu vorgesehen, daß die Verbindung jeweils zwischen den Ventilsitzen der beiden Ventile zur Mitte des Gasmischpunkts kleiner ist als 1/10 der Länge der Ableitung vom Gasmischpunkt bis zur Reaktionskammer.

Es hat sich weiterhin gezeigt, daß sich eine deutliche Verbesserung der Schichtqualität, insbesondere auch bei simultaner Beschichtung mehrerer Gegenstände erzielen läßt, wenn ein geradliniger Weg vom Gasmischpunkt zu der oder den Reaktionskammern vermieden wird. Die Ursache wird darin gesehen, daß bei einer geradlinigen Verbindung eine nur unvollständige Vermischung der Prozessgase auftreten kann. So kann es dann bei mehreren parallel betriebenen Reaktionskammern dazu kommen, daß die in den einzelnen Kammern einströmenden Gasgemische unterschiedliche Zusammensetzungen aufweisen. Um solche Probleme zu vermeiden, ist außerdem eine Ausführungsform der erfindungsgemäßen Beschichtungsanlage zum Beschichten von Gegenständen mit Wechselschichten bei der die Ableitung zur Reaktionskammer nun eine Umwegleitung umfasst, welche mit mehreren Umlenkungen zur Reaktionskammer verläuft, so daß eine turbulente Vermischung der im Gasmischpunkt miteinander in Kontakt gebrachten Gase erfolgt.

Die Umwegleitung kann dazu in einfacher Weise als Rohr mit mehreren Umlenkungen oder Knicken ausgebildet sein. Alternativ oder zusätzlich können Hindernisse in der Leitung eingebaut sein, die zu Verwirbelungen des Gasstroms führen.

Hinsichtlich des Leitungssystems von der Gaszuführungseinrichtung zu den Reaktionskammern hat es sich außerdem als besonders vorteilhaft erwiesen, wenn eine Leitung des Leitungssystems in jeweils genau zwei Leitungen aufgespalten wird. Diese Konfiguration der Zuleitungen führt überraschend zu einem besonders sicheren Zünden des Plasmas in allen angeschlossenen Reaktionskammern und außerdem zu einer exakten Aufteilung des Gasstroms, so daß in allen Reaktionskammern möglichst gleiche Gasdrücke hergestellt werden können. Dementsprechend ist gemäß noch einer alternativen oder zusätzlichen Ausführungsform der Erfindung eine Beschichtungsanlage zum gleichzeitigen Beschichten mehrerer Gegenstände mit Wechselschichten mittels plasmaunterstützter chemischer Dampfphasenabscheidung mit mehreren Reaktionskammern oder Einrichtungen, um mit zu beschichtenden Gegenständen Reaktionskammern zu bilden, vorgesehen, in welcher zu beschichtende Gegenstände anordenbar sind, eine Gaszuführungseinrichtung mit einer Ableitung zu den Reaktionskammern und eine Einrichtung zur Einstrahlung elektromagnetischer Energie, um ein Plasma im vom Prozessgas ausgefüllten Bereich in den Reaktionskammern zu zünden. Dabei ist die Ableitung in mehrere Abzweige aufgeteilt, welche jeweils an eine Reaktionskammer angeschlossen sind, wobei von einer Leitung des Leitungssystems mit Ableitung der Gaszuführungseinrichtung und den Abzweigungen von einer Leitung jeweils genau zwei Abzweige abgehen, so daß die Ableitung in $2^n$, n=2, 3,... Abzweigleitungen aufgespalten ist und die Zuleitungen zu jeder Kammer gleich oft aufgeteilt sind. Ein solches Leitungssystem ähnelt daher gewissermassen einem Baum, wobei die Hauptleitung in zwei Abzweige und jeder Abzweig wieder in zwei weitere Abzweige aufgespalten sind. Für n>2 und eine entsprechende Anzahl von Reaktionskammern ist diese Art und Weise der Verdopplung der Zuleitung entsprechend oft wiederholt.

Das entsprechende mit dieser Beschichtungsanlage ausführbare Verfahren basiert darauf, daß mehrere zu beschichtende Gegenstände in mehreren Reaktionskammern angeordnet oder mehrere Reaktionskammern mit zu beschichtenden Gegenständen gebildet werden, zumindest die Beschichtungsbereiche der Reaktionskammern evakuiert, und Prozessgas in die Beschichtungsbereiche geleitet und ein Plasma zur Abscheidung gezündet wird, so daß eine Beschichtung abgeschieden wird, wobei das Einleiten der Prozessgase in die Reaktionskammern mittels einer von einem Gasmischpunkt ausgehenden Ableitung erfolgt. Dabei werden verschiedene Gase des Prozessgases im Mischpunkt gemischt und der Gasstrom über die Ableitung in $2^n$, n=2, 3,... Abzweigen in entsprechend viele Teilströme aufgeteilt, welche jeweils in eine Reaktionskammer geleitet werden, wobei jeder Teilstrom gleich oft aus dem Gasstrom herausgeteilt wird und bei jeder Teilung der Gasstrom in genau zwei Teilströme geteilt wird.

Diese Art und Weise der Aufteilung der Gasströme hat sich hinsichtlich der Zündsicherheit des Plasmas in den einzelnen Reaktionskammern als überlegen gegenüber einer Aufteilung erwiesen, bei welcher der Gasstrom an gleicher Stelle in mehr als zwei, beispielsweise vier Teilströme aufgeteilt wird. Dies gilt sogar gegenüber einer Gasverteilung, bei welcher etwa eine symmetrische Anordnung von vier an einem Punkt der Ableitung ausgehenden Abzweigen realisiert ist.

Die Gleichmäßigkeit der Aufteilung des Gasstroms kann weiterhin auch noch dadurch verbessert werden, indem die Abzweigleitungen in einer Ebene von der Ableitung abzweigen. Hierbei kann insbesondere auch noch ein modularer Aufbau der Beschichtungsanlage realisiert werden, bei welchem mehrere Gasmischpunkte vorgesehen sind, die entlang einer Richtung quer zur Ebene, in welcher die Abzweigungen liegen, vorzugsweise senkrecht zu dieser Ebene angeordnet sind. Bei dieser Ausführungsform der Erfindung können dann die einem Gasmischpunkt zugeordneten Einheiten mit Reaktionskammern als Module aufgebaut sein, die in beliebiger Anzahl aneinandergereiht werden können.

Die Abscheidung der Schichten kann weiterhin vorteilhaft mit einer Spektrometeranordnung zur zeitaufgelösten Erfassung von Emissionslinien und/oder Spektren, welche bei der Beschichtung innerhalb der Reaktionskammer entstehen, überwacht werden. Anhand der Erfassung der Spektren und/oder Emissionslinien kann unter anderem vorteilhaft auch die zeitliche Steuerung der Ventile, Massenflussregler und/oder die Druckregelung nachgeregelt werden.

Die Erfindung wird nachfolgend anhand bevorzugter Ausführungsformen sowie unter Bezugnahme auf die beigefügten Zeichnungen detaillierter beschrieben.

Es zeigen

Fig. 1        Teile einer Beschichtungsanlage,

Fig. 2        eine Weiterbildung der in Fig. 1 gezeigten Beschichtungsanlage mit mehreren Modulen, die jeweils mehrere Reaktionskammern aufweisen.

Fig. 3        eine schematische Darstellung einer charakteristischen Pulszugform von Precursorgasen, welche sich in der in Figur 1 oder Figur 2 dargestellten Gaszuführung der CVD- Beschichtungsanlage, insbesondere der PICVD- Beschichtungsanlage befinden,

Fig. 4 und        Fig. 5 Diagramme mit praktischen Werten für Pulspausen bei der Abscheidung von $TiO_2/SiO_2$- Wechselschichten auf verschiedenen Substraten,

Fig. 6        eine optische Anordnung zur Erfassung der in Fig. 3 dargestellten Pulzugformen von Precursorgasen, insbesondere zur Messung deren zeitlicher Dichteverläufe,

Fig. 7        eine schematische Darstellung einer CVD- Beschichtungsanlage, insbesondere einer PICVD- Beschichtungsanlage mit einer Einrichtung zur Zuführung von Precursorgasen und einer Spektrometeranordnung zur zeitaufgelösten Erfassung von Spektren, welche bei der Beschichtung innerhalb der Reaktionskammer entstehen,

Fig 8A bis 8C        ein Schema der zur Abscheidung eines Wechselschichtsystems eingesetzten Pulsserien,

Fig. 9 ein        Schema der Synchronisation von Plasma- Pulsserien und Ventilen.

Detaillierte Beschreibung der Erfindung

Nachfolgend wird die Erfindung anhand bevorzugter Ausführungsformen detaillierter beschrieben, wobei jedoch die in den Figuren vorgenommenen Darstellungen lediglich beispielhaft der Erläuterung dienen und nicht maßstabsgerecht sein sollen.

Mit der Erfindung soll insbesondere auch ein schneller, sauberer Gaswechsel für einen CVD-Prozess, bevorzugt einen PECVD- oder PICVD-Prozess mit zwei oder mehreren Reaktionsgasen ermöglicht werden, insbesondere für CVD-Hochratenprozesse und für große CVD-Anlagen mit mehreren Modulen, in welchen große Gasmengen in relativ schnellem Wechsel zur Verfügung gestellt werden müssen (für Wechselschichten) und diese Gasmengen präzise, d. h. gleichmäßig, auf alle Module verteilt werden müssen. Eine gleichmäßige Verteilung ist sehr wichtig, weil die Menge an zur Verfügung gestelltem Gas direkt in die aktuelle Beschichtungsrate auf der jeweiligen Beschichtungsstation eingeht.

Wichtige Aspekte der Erfindung umfassen dabei insbesondere das Umschalten der Ventile der Zuleitungen zum Gasmischpunkt, einen Gasmischpunkt mit Totraum-Minimierung der Gaszuführung, sowie eine Umwegleitung, welche als Mischleitung ausgebidet ist sowie ein Verteilerrohr, welches als Doppelrohr aufgebaut ist und eine jeweilige Stationsaufteilung, bevorzugt in Modulbauweise.

Bei der nachfolgenden Beschreibung der Erfindung werden bevorzugte und besonders bevorzugte Eigenschaften der Erfindung beschrieben, welche hierbei jeweils auch in Kombination in weiteren, nicht im Detail beschriebenen Ausführungsformen verwendbar sind.

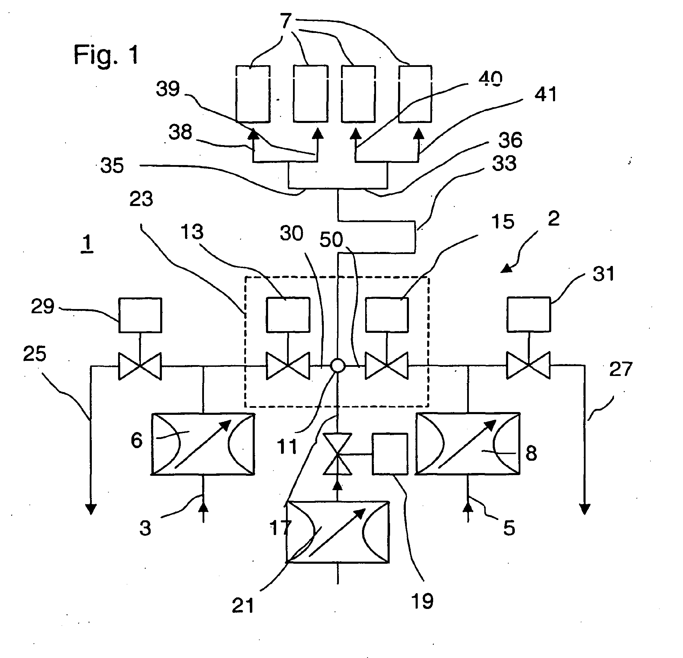

Fig. 1 zeigt dazu einen Teil einer Beschichtungsanlage 1 mit einer Gaswechseleinrichtung 2 und den Reaktionskammern 7. Die Gaswechseleinrichtung 2 umfasst zwei Zuleitungen 3, 5 für verschiedene Precursor-Gase. Beispielsweise kann über eine der Leitungen 3,5 ein Silzium- und über die andere der Leitungen 3, 5 ein Titan-Precursorgas zugeführt werden. Die Regelung der Gasflüsse der Precursor-Gase erfolgt mit Massenflussreglern 6, 8. Die Zuleitungen 3, 5 münden absperrbar mittels der Ventile 13, 15 in einen Gasmischpunkt 11. Außerdem mündet in diesem Gasmischpunkt 11, der in der Verbindung zwischen den beiden Ventilen angeordnet ist, eine Zuleitung 17 für ein weiteres Gas, welches mit dem oder den jeweils zugeschalteten Precursor-Gasen im Gasmischpunkt 11 gemischt wird. Auch die Zuleitung 17 ist mittels eines Ventils 19 absperrbar und der Gasfluss durch diese Leitung 17 ist mit einem Massenflussregler 21 geregelt.

Die Gaswechseleinrichtung 2 umfasst außerdem zwei BypassLeitungen 25, 27, die jeweils vor den Ventilen 13, 15 von den Zuleitungen 3, 5 abzweigen und die jeweils mit einem Ventil 29, beziehungsweise 31 absperrbar sind. Diese Bypass-Leitungen sind an eine oder mehrere Pumpen angeschlossen.

Nachfolgend wird anhand von Fig. 1 eine bevorzugte Ausführungsform einer erfindungsgemäßen Ventil-Umschaltung beschrieben.

Die Abscheidung von Multilagen-Schichtsystemen erfordert den Wechsel zwischen verschiedenen Precursorgasen für die einzelnen Schichtmaterialien. Für die Qualität des Schichtsystems, insbesondere der Grenzflächenbereiche zwischen den Einzelschichten, ist ein möglichst schneller aber zugleich möglichst vermischungsfreier Gaswechsel erforderlich. Dies kann durch eine stationäre, kontinuierliche Strömung der Precursorgase über die gesamte Dauer des Beschichtungsprozesses erreicht werden. Diese stationäre Strömung eines Precusorgases wird, falls gerade das entsprechende Schichtmaterial abgeschieden wird, in den Gasmischpunkt 11 geleitet, wobei in der Zuleitung das Ventil 13 oder 15, je nach gefordertem Precursor-Gas geöffnet und das Ventil 29, beziehungsweise 31 in der Bypass-Leitung geschlossen ist.

Im anderen Fall fließt die Gasströmung in die Bypassleitung 25, beziehungsweise 27, wobei das jeweilige Ventil 13, beziehungsweise 15 geschlossen ist.

Entscheidender Vorteil dieses Prinzips ist, daß kein Einschwingvorgang der Gasströmung, insbesondere keine Beschleunigung einer zunächst stehenden Gassäule erforderlich ist, bis ein stationärer Strömungszustand erreicht ist. Der Wechsel von einem Precursorgas auf ein anderes kann daher nahezu synchron erfolgen. Der Druck in den Bypassleitungen der Precursorgase wird dabei identisch zu dem Druck im Gasmischpunkt eingestellt sodaß unabhängig davon, ob das Precursor-Gas mit den Ventilen in den Mischpunkt 11 oder in die jeweilige Bypass-Leitung 25, beziehungsweise 27 geleitet wird, möglichst identische Druckverhältnisse herrschen. Die Bypassleitungen 25, 27 spiegeln gewissermaßen den Gasmischpunkt 11 für den Fall, daß das entsprechende Precursorgas im Prozess gerade nicht benötigt wird.

Die Gasversorgung mit Precursorsubstanzen wird also durch Kombination von jeweils zwei Ventilen 13, 29, beziehungsweise 15, 31 für jede Gaszuleitung 3, 5 realisiert.

Das Gas wird dann entweder mit Sauerstoff aus der Leitung 17 beigemischt direkt in die Reaktionskammern 7 geführt oder ungenutzt über die Bypass-Leitung 25, oder 27 direkt zur Pumpe abgeführt.

Das abwechselnde Umschalten zwischen den beiden (zumindest zwei) Gasen geschieht dabei synchron, d.h. es werden nahezu zeitgleich immer zwei Ventile gleichzeitig geschaltet. Insgesamt gibt es drei mögliche Ventilstellungen beim Einsatz zweier Precursorgase (zum Beispiel $TiCl_4$ und HMDSO zur Erzeugung von $TiO_2$ und $SiO_2$-Wechselschichten) wobei zusätzlich Sauerstoff als Reaktionsgas am Gasmischpunkt über die Zuleitung 17 mit eingeleitet wird. In der nachfolgenden Tabelle der Ventilstellungen wird angenommen, daß über die Leitung 3 HMDSO als Silizium-Precursor und über die Leitung 5 $TiCl_4$ als Titan-Precursor zugeleitet werden:

| aktueller Prozess | Si-Ventil | Si-Ventil | Ti-Ventil 15 | Ti-Ventil | $O_2$-Ventil |
|---|---|---|---|---|---|
| kein | zu | offen | zu | offen | zu |
| Ti- | zu | offen | offen | zu | offen |
| Si- | offen | zu | zu | offen | offen |

Eine besonders bevorzugte Ausführungsform umfasst ferner einen Gasmischpunkt mit einer Totraum-Minimierung, insbesondere in einem Mischpunkt-Ventil. Dieses Mischpunktventil zeichnet sich dadurch aus, dass es den Totraum zwischen den beiden Gaszuleitungen 3, 5 absolut minimiert. Hierzu werden die beiden Ventile 13, 15 der beiden Gaszuleitungen 3, 5 mit ihren Ventilsitzen möglichst nahe aneinander herangebracht.

Die Abschnitte 30, 50 der Zuleitungen 3, 5 zwischen den Ventilen 13, 15 und des Gasmischpunkts 11 sind möglichst kurz gehalten, um bei abgesperrten Ventilen 13, 15 eine möglichst schnelle Abführung des in diesen Abschnitten vorhandenen Gases bei einem Prozessgas-Wechsel zu erreichen. Dazu sind die Ventilsitze der Ventile 13, 15 mit dem Gasmischpunkt 11 in einer Mischpunktventil-Einheit in Form eines Ventilblocks 23 integriert, d.h. die beiden Ventilsitze sind selbst Bestandteil des Ventilblocks.

Die beiden Gaszuleitungen 30, 50 in der Nähe des Gasmischpunktes 11 sollten erfindungsgemäß vorzugsweise also so gestaltet sein, dass der Leitungsweg zwischen den beiden Ventilen 13, 15 möglichst kurz ist.

Ein solches Mischpunktventil für die Mischung zweier Gase weist bevorzugt 4 Anschlüsse auf:

zwei Zuführungen der beiden Gase (mit sehr kurzen Leitungen zwecks Totraumminimierung),(mindestens) eine Zuführung für den Sauerstoff,(mindestens) eine Ableitung des Gasgemisches zum CVD-Reaktor.

Nachfolgend wird der Zweck der Totraum-Minimierung beschrieben.

In einem aktiven Beschichtungsprozesszustand, d.h. wenn ein Ventil 13 oder 15 geöffnet und das andere geschlossen ist, kann das für diese Beschichtung benötigte Gas in die Gasleitung des anderen Gases bis zu dessen Ventil eindringen. Wenn das Gas gewechselt wird, was bei optischen Wechselschichten im allgemeinen bei jedem Umschalten von einem Beschichtungsmaterial zum nächsten der Fall ist, wird nach dem synchronen Umschalten der Ventile zunächst noch etwas von dem Gas des vorherigen Beschichtungsschritts mit dem neuen Gas der jetzt erwünschten Beschichtung durchmischt in die CVD-Kammer transportiert und dort als Beschichtung niedergeschlagen. Dadurch ist im ersten Augenblick jedes Beschichtungschrittes die Gaszusammensetzung nicht genau definiert und damit können auch keine präzisen, sauber voneinander getrennten dünnen Einzelschichten in Wechselschichtsystemen für optische Anwendungen abgeschieden werden.

Dieses würde ansonsten beim Anfahren des jeweils nächsten Beschichtungsprozesses in einem Wechselschichtsystem zu Schwierigkeiten führen und die Anlage müsste stattdessen bei jedem Beschichtungswechsel erst längere Zeit gespült werden, um die unerwünschten Gase des vorherigen Beschichtungsschrittes wieder soweit auszuspülen, dass der nächste Schritt im Beschichtungsprozess beginnen kann.

Die Massenflussregelung des Gaszuführungssystems wird realisiert durch den Einbau eines Nadelventils oder einer sehr kleinen Blende mit angepasstem fixem Durchmesser in jeder der Zuführungsleitungen, also in der druckgeregelten Zuleitung 3, beziehungsweise 5 jedes Precursorgases und in der druckgeregelten Zuführungsleitung 17 für Sauerstoff. Die Bypassleitungen 25, 29 sind ebenfalls druckgeregelt. Die Ausführung der Nadelventile bzw. Blenden sowie die Einstellung der Drücke in den zufahrenden Leitungen ist derart gewählt, daß am Ort der Nadelventile bzw. Blenden eine stark beschleunigte und im Wesentlichen von Rückwirkungen befreite Strömung auftritt. Für die Druckverhältnisse setzt dies voraus, dass die Drücke in den jeweiligen Verteilerleitungen, d.h. die Vordrücke an den Nadelventilen bzw. Blenden mehr als das Doppelte des Hinterdruckes betragen. Der Hinterdruck entspricht dem Druck im Gasmischpunkt 11, in dem die verschiedenen Prozeßgase zusammengeführt werden.

Das Prinzip der starken Beschleunigung der Strömung bietet mehrere Vorteile:

Der Massenfluß durch die Nadelventile ist direkt proportional dem anliegenden Vordruck in den Verteilerleitungen und vom Hinterdruck (= Mischpunktsdruck) unabhängig. Druckänderungen am Gasmischpunkt 11 können daher den Massenfluß der einzelnen Prozeßgase nicht beeinflussen. Durch Variation der Verteilerdrücke kann daher auf einfache Weise der Massenfluß eingestellt bzw. geändert werden.

Die starke Beschleunigung der Strömung verhindert den Rücktransport von Gasmolekülen durch Diffusion oder Strömung vom Gasmischpunkt 11 in die Zuleitungen. Eine rückwirkende Vermischung der verschiedenen Precursorgase ist somit ausgeschlossen. Darüberhinaus verhindert die starke Beschleunigung der Strömung im Falle einer Flammenbildung am Gasmischpunkt oder dahinter (in Richtung der Reaktionskammern 7) ein rückseitiges Durchschlagen der Flammenfront in Richtung der Gaserzeugungsquelle. Damit wird eine Flammrückschluss-Sperre geschaffen.

Der Druck im Gasmischpunkt 11 hängt von der zugeführten Sauerstoffmenge, von der Geometrie des Gasmischpunktes und der Leitung zu der CVD-Reaktorkammer sowie von dem Druck in der CVD-Reaktorkammer ab. Die Menge der Precursorgase ist im Vergleich dazu für bevorzugte Betriebsweisen, bei welchen mehr als 70% Sauerstoff im Prozessgasgemisch enthalten sind, vernachlässigbar.

Ein typischer Wert für den Druck am Gasmischpunkt ist z.B. 10 mbar. Die Drücke in den zum Gasmischpunkt fahrenden Zuleitungen 3, 5, 17 vor den Massenflussreglern 6, 8, 21 werden in diesem Fall auf mindestens 20 mbar eingestellt und somit die starke Beschleunigung des Gases gewährleistet. Erfordert die Beschichtung bestimmter Substrate eine deutliche Erhöhung des Sauerstoffflusses, resultiert daraus eine Erhöhung des Druckes im Gasmischpunkt 11. In diesem Fall sind ggfs. die Drücke in den Verteilerleitungen ebenfalls zu erhöhen, um die starke Beschleunigung in den Strömungsverhältnissen zu garantieren.

Wenn zwischen Vordruck und Hinterdruck mindestens ein Faktor 2 herrscht, wirken sich Druckänderungen hinter dem Nadelventil, etwa des jeweiligen Massenflussreglers 6, 8, 21 nicht auf den Massenfluss durch das Nadelventil aus. Es wird sich exakt derselbe Massenfluss durch das Nadelventil einstellen, unabhängig davon, ob dahinter ein geringer Druck oder ein höherer Druck herrscht, solange der Faktor 2 oder größer noch erreicht wird. Grundlage hierfür ist das physikalische Prinzip der starken Beschlunigung. Wird die Gaszuführung zur Gasversorgung einer CVD-Anlage mit druckgeregelten Zuleitungen und ebensolchen Ableitungen zusätzlich mit Nadelventilen in den Gaszuleitungen ausgestattet und diese so eingestellt, dass an den Nadelventilen der Zustand starker Beschleunigung der Strömung in Strömungsrichtung der Gaszuführung herrscht, so lässt sich die Gasregelung viel exakter und nahezu absolut rückwirkungsfrei gestalten als wenn die Nadelventile nicht in dem Gaszuführungssystem enthalten wären oder diese nicht so eingestellt wären, dass der physikalische Zustand dieser Beschleunigung herrschen würde.

Würde diese erfindungsgemäße Maßnahme in der Gasversorgung einer CVD-Anlage nicht realisiert werden (d.h. wären keine Nadelventile eingebaut oder diese zu weit geöffnet sein, so dass sich der Zustand der starken Beschleunigung nicht einstellt), würden Druckänderungen am Gasmischpunkt bei einem Precursorgas insbesondere bei jedem Umschalten auf die Bypass-Leitungen und umgekehrt zwangsweise auch zu einer Änderung des Massenflusses des betreffenden Precursorgases führen, d.h. es würde eine Rückwirkung stattfinden.

Diese Rückwirkung würde zu einer linearen Abhängigkeit (Zunahme bzw. Abnahme des Massenflusses des betreffenden Precursorgases) führen, wenn sich der Druck weit ab vom Zustand dieser starken Beschleunigung der Strömung in Strömungsrichtung befinden würde (also der Druck am Gasmischpunkt nicht um mindestens einen Faktor 2 kleiner wäre als der Druck in der druckgeregelten Zuführungsleitung).

Neben dieser erfindungsgemäßen Verhinderung der Rückwirkung durch die Erzeugung des Zustands dieser Beschleunigung dient diese Beschleunigung auch als Flammschutz und soll im Falle einer Flammenbildung am Gasmischpunkt oder dahinter (in Richtung der CVD-Reaktoren oder Reaktionskammern) eine rückseitiges Durchschlagen der Flammenfront in Richtung auf die Gaserzeugungsquelle (große Mengen brennbarer und/oder explosionsfähiger Reaktionschemikalien in großen Vorratsbehältern) vermeiden (Flammrückschlusssperre).

Dabei muss zur Beschleunigung auf der Gaserzeugerseite ein mindestens doppelt so hoher Druck wie auf der anderen, dem Ventilblock zugewandten Seite herrschen.

Eine besonders bevorzugte Ausführungsform der Erfindung umfasst ferner eine Umwegleitung 33 als Bestandteil der Ableitung vom Gasmischpunkt 11 zu den Reaktionskammern 7.

Aus dem Blockventil 23 werden die beiden im Gasmischpunkt zusammengeführten Gase zu den Reaktionskammern 7 weitergeführt. Dabei müssen sich die beiden zusammengeführten Gase gründlich durchmischen. Da die beiden Gase im Gasmischpunkt aus den beiden Zuleitungen von zwei Seiten aus in die gemeinsame Ableitung fließen, werden sie sich von selbst bei den herrschenden Drücken nicht und nur ungenügend vermischen (keine turbulente Strömung). Daher wird erfindungsgemäß auf dem Weg zum Reaktor für eine genügend gute Durchmischung durch Anregung von Turbulenzen gesorgt. Dieses kann prinzipiell durch verschiedene mechanische Maßnahmen erreicht werden, z.B. durch das Einbringen von (insbesondere scharfkantigen) Hindernissen, die zu Strömungsabrissen und damit zu Verwirbelungen führen. Eine bevorzugte erfindungsgemäße Maßnahme ist jedoch, wie in Fig. 1 gezeigt, das Verlegen der Leitung zum Reaktor in Form von Umwegleitungen mit Schleifen, S-Kurven, mäanderförmig usw., wobei in den Bögen jeweils eine turbulente Vermischung der mindestens zwei Gasarten stattfindet.

Dem in den bevorzugten Ausführungsformen verwendetem Verteilerrohr kommt wichtige Bedeutung zu, denn das Verteilerrohr hat die Aufgabe, das ankommende Gasgemisch möglichst gleichmäßig zu den einzelnen Beschichtungsstationen zu leiten.

Vorteilhaft für die möglichst gleichmäßige Verteilung des Gasflusses auf die Vielzahl von Abzweigungen zu den einzelnen Beschichtungsstationen ist zusätzlich noch das konstruktive Merkmal, dass das Verteilerrohr als Doppelrohr aufgebaut ist: In einer Ebene, z.B. oben, verläuft das zentrale Zuleitungsrohr mit der Aufteilung des Gasflusses auf die einzelnen Ableitungen zu den Beschichtungsstationen, während in einer anderen Ebene, z.B. unterhalb dieser Ebene, eine oder mehrere Abführleitung(en) zu der Pumpe angeordnet sind.

Dadurch hat die Abführleitung mit ihrer starken Saugkraft praktisch keinen Einfluss mehr auf den Gasfluss und damit auf den Massenfluss in die einzelnen Abzweigungen.

Würde sich im anderen Fall der Anschluss der Abführleitung auf derselben Ebene wie die Vielzahl der Abzweigleitungen befinden, wäre die Saugkraft aufgrund eines sich aufbauenden Druckgradienten auf die in der Nähe befindlichen Abzweigleitungen größer als auf die weiter hiervon entfernt liegenden und die in der Nähe liegenden würden anteilig etwas weniger mit Gasstrom versorgt werden. Für eine gleichmäßige Versorgung der Vielzahl von Ableitungen zu den einzelnen Beschichtungsstationen ist es außerdem sehr vorteilhaft, wenn diese vom Versorgerrohr abgehenden Ableitungen alle denselben Abstand voneinander haben.

Für den Aufbau einer erfindungsgemäßen CVD-Beschichtungsanlage ist es insbesondere vorteilhaft, wenn jede in der Anlage vorhandene Verteilerleitung nach diesem Konstruktionsprinzip gebaut wird.

In dem beispielhaften Blockschaltbild der Fig. 1 sind insgesamt 5 Zuleitungen enthalten: je eine Zu- und eine Ableitung, beziehungsweise Bypass für jede der beiden Gasarten sowie eine Zuführung für Sauerstoff. Es ist vorteilhaft, wenn jede dieser Verteilerleitungen nach dem erfindungsgemäßen Konstruktionsprinzip ausgebildet ist, um insgesamt einen möglichst gleichmäßigen Gasfluss zu erzielen.

Besonders bevorzugt wird bei einer weiteren Ausführungsform eine Stationsaufteilung in Modulbauweise vorgenommen.

Es ist zwar möglich, für jede einzelne Reaktionskammer 7 einen einzelnen Gasmischpunkt 11 mit Schaltung der zugehörigen Ventile 13, 15, 29, 31 mit einem Ventilblock 23 zu bauen, wie oben ausgeführt, es ist aber besonders vorteilhaft, aus einem Gasmischpunkt 11 stattdessen hinter der anschließenden Mischleitung, beziehungsweise Umwegleitung 33 zwecks Erzeugung von Turbulenzen eine Abzweigleitung in mehrere einzelne separate Einzelleitungen aufzuspalten, die jeweils in eine Beschichtungsstation führen.

Erfindungsgemäß ist es dabei besonders vorteilhaft, diese Aufteilung in eine Anzahl von "2 hoch n", mit n = 2,3,... aufzuspalten, da hierbei auf konstruktiv einfache Art eine gleichmäßige Aufspaltung des Massenflusses auf eine Vielzahl von einzelnen Beschichtungsstationen möglich ist.

Hierbei wird die vom Gasmischpunkt 11 kommende Abzweigleitung zunächst symmetrisch in zwei Leitungen 35, 36 aufgeteilt. Diese beiden Leitungen können dann jeweils wieder symmetrisch, wie in Fig. 1 gezeigt, wiederum in zwei weitere Leitungen 38, 39, beziehungsweise 40, 41 aufgespalten werden können usw., so dass von einem Gasmischpunkt aus 2,4,8,16... einzelne CVD-Beschichtungsreaktoren, beziehungsweise Reaktionskammern 7 mit einem gleichmäßigen Massenstrom an Gas versorgt werden können.

Diese Ausführungsform der Erfindung basiert demgemäß darauf, daß die Ableitung vom Gasmischpunkt 11 in mehrere Abzweige 38, 39, 40, 41 aufgeteilt ist, welche jeweils an eine Reaktionskammer 7 angeschlossen sind, wobei von einer Leitung des Leitungssystems mit Ableitung der Gaszuführungseinrichtung und den Abzweigungen von einer Leitung jeweils genau zwei Abzweige abgehen, so daß die Ableitung in $2^n$, n=2, 3,... Abzweigleitungen aufgespalten ist und die Zuleitungen zu jeder Reaktionskammer 7 gleich oft aufgeteilt sind.

Besonders vorteilhaft bei dieser Aufspaltung in jeweils zwei Leitungen ist es dabei, wenn die nacheinander folgenden Aufspaltungen in ein und derselben Ebene (Fläche) geschehen. Dadurch ist es möglich, in der dritten Dimension eine beliebige Anzahl von Gasmischpunkten 11 hintereinander zu reihen, ohne dass dabei noch besondere Einschränkungen in Hinsicht auf Anzahl oder Symmetrien zu beachten sind. So ist z.B. in einer Modulbauweise in einer Anlage möglich, 12 Gasmischpunkte hintereinander zu realisieren, wobei von jedem Gasmischpunkt aus die Abzweigleitung durch doppelt hintereinander geschaltete Aufspaltungen auf jeweils zwei Leitungen insgesamt 12 x 4 = 48 einzelne Beschichtungsreaktoren gleichmäßig mit Gas versorgt werden können.

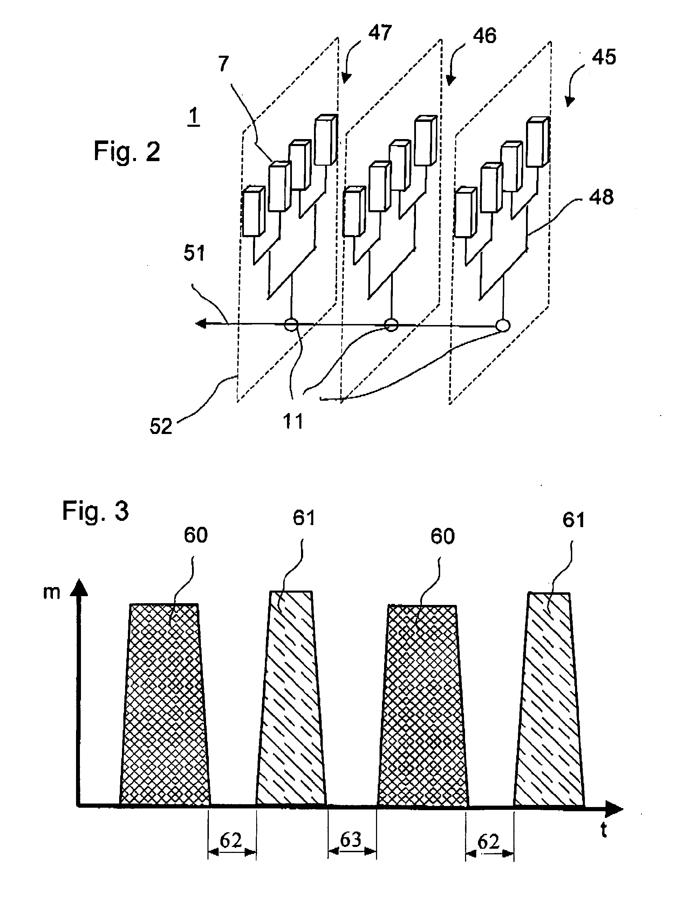

Eine schematische Darstellung einer derartigen Weiterbildung der Erfindung ist in Fig. 2 in schematischer perspektivischer Ansicht dargestellt. Die Beschichtungsanlage 1 umfasst mehrere Module 45, 46, 47, mit jeweils wiederum mehreren Reaktionskammern 7. Die Reaktionskammern 7 sind dabei jeweils in den Modulen 45, 46, 47 an ein Gaszuführungssystem 48 angeschlossen, welches wie oben beschrieben eine Aufteilung der vom Gasmischpunkt 11 des Moduls ausgehenden Ableitung in 2n Abzweige aufweist, wobei von jedem Verzweigungspunkt genau zwei Abzweige ausgehen und die in den Reaktionskammern 7 mündenden Abzweige jeweils gleich oft aufgeteilt sind. Bei dem gezeigten Beispiel ist die Ableitung von den Gasmischpunkten 11 in $2^2=4$ Abzweige aufgeteilt, die entsprechend in 4 Reaktionskammern 7 münden. Die Leitungen der Gaszuführungssysteme 48 liegen bei jedem Modul jeweils in parallelen Ebenen 52, wobei die Gasmischpunkte 11 entlang einer zu diesen Ebenen 52 senkrechten Richtung 51 aufgereiht sind.

Die Umschaltung der Ventilpaare 13, 29 und 15, 31 der in Fig. 1 gezeigten Ausführungsform für den Wechsel des Prozessgasgemischs muß nicht synchron erfolgen, sondern kann zeitversetzt sein. Zwar wird die Umschaltung der Ventile 13, 29 ebenso wie die Umschaltung der Ventile 15, 31 synchron durchgeführt, allerdings kann dabei mittels einer geeigneten Steuerung eine Pause zwischen dem Öffnen des Ventil 15 und dem Schließen des Ventils 13 und umgekehrt eingehalten werden. Diese Pause bewirkt, daß der Gasstrom in Form von diskreten Gaspulsen zu den Reaktionskammern geleitet wird, so daß sich die unterschiedlichen Prozessgasgemische aufeinanderfolgender Gaspulse nicht miteinander vermischen.

Fig. 3 zeigt zur Verdeutlichung ein Diagramm des zeitlichen Verlaufs des Massenflusses in der Ableitung zu den Reaktionskammern. Es werden abwechselnd Gaspulse 60 eines ersten Precursorgasgemischs und Gaspulse 61 eines zweiten Precursorgasgemischs vom Gasmischpunkt durch die Ableitung geleitet. Die Massenflüsse der Gaspulse 60, 61 können dabei auch unterschiedlich sein. Dies gilt insbesondere auch für deren Länge. So ist es beispielsweise bei der Abscheidung eines Interferenz-Wechselschichtsystems mit abwechselnd hoch- und niedrigbrechenden Schichten im allgemeinen sinnvoll, die Schichtdicken an deren optische Dicke anzupassen.

Will man etwa eine Abfolge von Lagen mit einer optischen Dicke von einer Viertelwellenlänge abscheiden, so ist die Lagendicke bei den niedrigbrechenden Lagen höher. Ist die Abscheiderate bei den hoch- und niedrigbrechenden Lagen ähnlich, so werden entsprechend die Gaspulse für die niedrigbrechenden Lagen länger eingestellt. So können bei dem in Fig. 3 gezeigten Diagramm die längeren Gaspulse 60 Gaspulse eines Gasgemischs mit einem Silizium-Precursor zur Abscheidung von $SiO_2$-Lagen und die kürzeren Gaspulse 61 Gaspulse eines Gasgemischs mit einem Titan-Precursor zur Abscheidung von höherbrechenden $TiO_2$-Lagen sein. Zwischen den Pulsen 60, 61 sind jeweils Pausen 62, 63 vorhanden, die nicht notwendigerweise gleich lang sein müssen. Es wird eine Steuerung des Gaswechselsystems angestrebt, bei welcher die Pausen 62, 63 möglichst kurz sind. Idealerweise wird ein Betrieb angestrebt, bei welchem die Gaspulse direkt aufeinanderfolgen, ohne daß eine Vermischung der Gassorten auftritt. Dementsprechend sollten die Pausen 62, 63 möglichst kurz sein, können im Idealfall auch verschwinden.

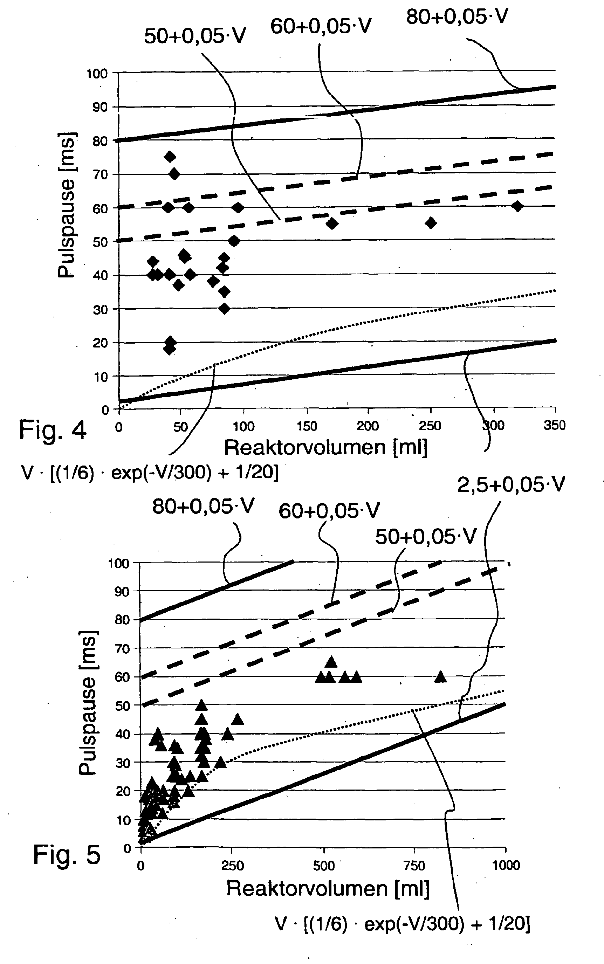

In den Diagrammen der Fig. 4 und 5 sind praktische Werte von Plasmapuls-Pausen bei der Abscheidung von TiO2/SiO2-Interferenz-Wechselschichten in Abhängigkeit des Reaktorvolumens dargestellt. Bei den in Fig. 4 gezeigten Werten wurden Glaskeramik-Reflektoren beschichtet. In Fig. 5 sind entsprechende Werte für die Beschichtung von Reflektoren aus Suprax-Glas dargestellt. Die dargestellten Werte erwiesen sich jeweils als besonders günstig, um qualitativ besonders hochwertige Wechselschichten mit scharfen Grenzflächen zu erhalten. Wie anhand der Diagramme zu erkennen ist, liegen alle Werte oberhalb der Geraden, für die die oben angegebene Beziehung P[ms]=2,5 + 0,05*V, vorzugsweise P[ms]=2,5 + 0,055*V gilt. Die Werte liegen außerdem unterhalb der durch P[ms]=80 + 0,05*V gegebenen Geraden. Die Pulspause zwischen zeitlich benachbarten Plasmapulsen kann also auf diese obere Grenze zeitlich begrenzt werden, ohne daß nachteilige Wirkungen auf die Ausbildung der Grenzflächen und der Schichtreinheit entstehen. Gemäß einer Weiterbildung der Erfindung können allgemein auch Pulspausen verwendet werden, die kürzer sind als P[ms]=60 + 0,05*V, oder sogar auch kürzer als P[ms]=50 + 0,05*V sind. In den Fig. 4 und 5 sind zwei Geraden eingezeichnet, die den beiden vorstehenden Beziehungen entsprechen. Anhand der Fig. 4 und 5 ist zu erkennen, daß diese Grenzwerte sowohl für Glassubstrate (Fig. 5), als auch für Glaskeramik-Substrate (Fig. 4), hier besonders bei größeren Reaktorvolumina, vorzugsweise größer als 100 Milliliter gut geeignet sind.

Gemäß noch einer Weiterbildung der Erfindung kann die Pulspause auch so gewählt werden, daß sie mindestens so lang wie das Maximum

$$P[ms] = max(\ 2,5 + 0,05*V,\ V\cdot[(1/6)\cdot exp(-V/300) + (1/20)])$$

ist. Die Funktion P[ms]=V·[(1/6)-exp(-V/300) + (1/20)] ist dabei jeweils in den Fig. 4 und 5 zur Veranschaulichung eingezeichnet. Insbesondere anhand der in Fig. 5 gezeigten Werte ist zu erkennen, daß diese Funktion die Untergrenze für eine optimale Beschichtung über einen weiten Volumenbereich hinweg gut annähert.

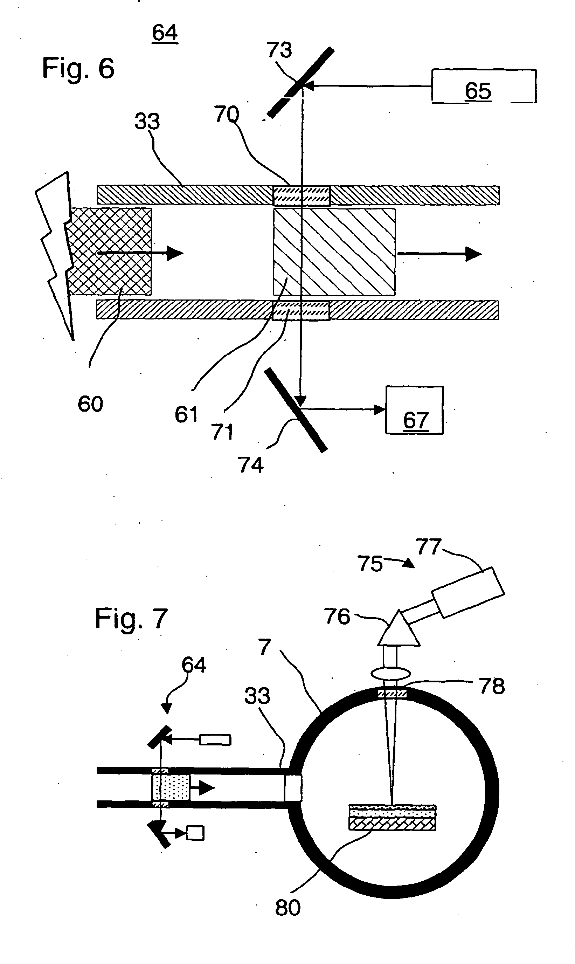

In Fig. 6 ist ein Ausführungsbeispiel einer optischen Anordnung 64 dargestellt, mit welcher der zeitliche Dichteverlauf oder der zeitliche Verlauf der Massenflüsse der Gaspulse erfasst werden kann. In der Ableitung vom Gasmischpunkt, beispielsweise in der Umwegleitung 33 sind Fenster 70, 71 vorgesehen, so daß der Lichtstrahl einer Lichtquelle 65 quer durch die Leitung 33 hindurch geleitet und der austretende Lichtstrahl mit einem Spektrometer 67 erfasst werden kann. Bei dem in Fig. 6 gezeigten Beispiel ist der Lichtstrahl außerdem über zwei Spiegel 73, 74 umgelenkt. Die Spiegel können selbst Teil des Spektrometers sein. So kann etwa der Spiegel 74 dichroitisch sein und nur angeregtes Fluoreszenzlicht reflektieren und das Licht der Lichtquelle hindurchlassen. Auch kann der Spiegel 74 ein Gitter sein, um eine spektrale Aufspaltung zu erzielen. Mit dem Spektrometer können Fluoreszenz- oder Absorptionslinien des Gasgemisches der durchgeleiteten Pulse 60, 61 erfasst und anhand deren Intensität der zeitliche Verlauf der Pulse 60, 61 überwacht werden. Auch kann die optische Anordnung 64 zur Steuerung der Gasversorgung, insbesondere der Gaswechseleinrichtung dienen. Mit der Anordnung kann nämlich ein Maß für die tatsächlich durchgeleitete Gasmenge erhalten werden. Eine Steuerung könnte dergestalt sein, daß die Ventile des jeweiligen Precursor-Gases umgeschaltet werden, wenn die anhand der Meßwerte bestimmte Gasmenge durchgeleitet ist. Die Umschaltung der Ventile für das weitere Precursorgas erfolgt dann nach der vorgegebenen Pulspause.

Auch kann in ähnlicher Weise eine Erfassung einer oder mehrerer Emissionslinien des Plasmas erfolgen. In diesem Fall wird die optische Anordnung in der Reaktionskammer oder außerhalb dieser angeordnet. Da das Plasma selbst leuchtet, kann die Lichtquelle 65 in diesem Fall entfallen. Auch eine Aufzeichnung der Intensität einer bestimmten Emissionslinie kann dazu verwendet werden, die Pulslänge der Gaspulse zu steuern.

Ein CVD-Reaktor mit einer solchen beispielhaften optischen Anordnung 75 ist schematisch in Fig. 7 dargestellt. An der Zuleitung zur Reaktionskammer 7 ist außerdem eine optische Anordnung gemäß Fig. 6 angeschlossen. In der Reaktionskammer 7 wird ein zu beschichtender Gegenstand 80 angeordnet und die Reaktionskammer evakuiert. Durch die Zuleitung, beispielsweise wieder eine Umwegleitung 33 werden Gaspulse eingeleitet und mittels einer nicht dargestellten Einrichtung zur Einstrahlung elektromagnetischer Energie im mit dem Prozessgas-Gemisch ausgefüllten Reaktorvolumen ein Plasma gezündet. Als Einrichtung zur Einstrahlung elektromagnetischer Energie kann zum Beispiel eine Mikrowellen-Quelle verwendet werden. Durch ein Fenster 78 in der Wand der Reaktionskammer 7 gelangt Licht, welches im Plasma entsteht, nach außen. Mit einem Prisma 76 wird das Licht in seine spektralen Bestandteile zerlegt und mit einer Kamera 77 oder einer anderen Erfassungseinrichtung aufgezeichnet. Die Intensität einer bestimmten Emissionslinie des PrecursorGases kann damit zeitaufgelöst erfasst werden, um ein genaues Maß für die Menge an abgeschiedenem Material zu erhalten. Auch diese Anordnung kann ebenso wie die optische Anordnung 64 demgemäß eingesetzt werden, um über die Gaswechseleinrichtung die Pulslänge der Gaspulse zu steuern.

Bei der vorstehenden Beschreibung der Erfindung umfasst der Begriff "Gegenstand" sowohl ebene als auch nicht ebene, dreidimensional geformte Substrate oder Erzeugnisse, wie beispielsweise optische Bauteile, Reflektoren, Linsen, opthalmische Gläser oder Kunststoffe, wie zur Verwendung in Brillen, Displaygläser, Kfz-Teile, wie beispielsweise Instrumenten-, Leuchtmittelabdeckungen oder Scheiben, Lampen oder Leuchtmittel, beispielsweise Blinkerbirnchen, Halogen-, insbesondere H3- und H4-Birnen oder Hochdruckleuchtmittel.

Die vorstehend beschriebene Beschichtung kann der spektralen Einflussnahme und/oder der Änderung des Reflexions- und/oder des Absorptionsvermögens dienen.

Durch die besonders präzise Steuerung der Dichte, der Zusammensetzung sowie der Dicke der Schicht können ferner auch Barriere- oder definierte Migrationsschichten mit der Erfindung erzeugt werden.

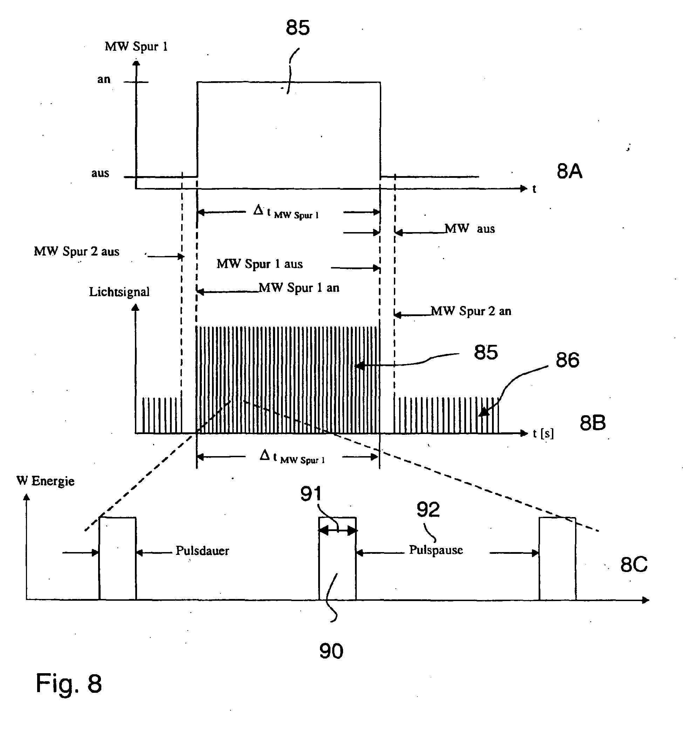

Die Fig. 8A bis 8C zeigen ein Schema der zur Abscheidung eines Wechselschichtsystems eingesetzten Pulsserien. Für die Abscheidung der sich in ihrer Zusammensetzung unterscheidenden Lagen des Wechselschichtsystems können neben einer unterschiedlichen Prozessgaszusammensetzung unterschiedliche Parameter, wie insbesondere Pulshöhe, Pulsdauer, Pulspause und evtl. auch Pulsform der elektromagnetischen Pulse eingesetzt werden. Die Pulsserien mit diesen Parametern werden im folgenden auch als "Spuren" bezeichnet. Im Zeitdiagram der Fig. 8A ist eine solche als Spur 1 bezeichnete Spur 85 dargestellt. Während der Zeitdauer $\Delta t_{MW\ Spur\ 1}$ wird die Quelle, hier eine Mikrowellenquelle gepulst betrieben, so daß während dieser Zeitdauer eine Pulsserie von Plasmapulsen erzeugt wird. In Fig. 8B ist dazu das Lichtsignal des Plasmas als Funktion der Zeit dargestellt. Fig. 8C zeigt einen zeitlich gestreckten Ausschnitt aus dem Diagramm der Fig. 8B. Die Plasmapulse 90 weisen eine Länge der Dauer 91 auf und sind durch Pausen 92 zeitlich beabstandet, wobei bei dem gezeigten Beispiel die Pausen 92 länger gewählt sind als die Pulsdauern 91.

Die Plasmapulse der Pulsserien äußern sich als Lichtblitze, wobei, wie anhand des Beispiels der Fig. 8B gezeigt ist, die Lichtblitze unterschiedlicher Spuren auch unterschiedliche Intensität haben können. Auch die Pulspausen sind bei dem in Fig. 8B gezeigten Beispiel für die Spuren 85, 86 unterschiedlich.

Weiterhin ist zu erkennen, daß die Mikrowellenpulse zwischen den beiden Spuren 85, 86 unterbrochen werden. Die Zeitdauer "MW aus" dieser Unterbrechung, also die Dauer zwischen den Zeitpunkten "MW Spur 2 aus" und "MW Spur 1 an", beziehungsweise "MW Spur 1 aus" und "MW Spur 2 an", ist dabei allgemein länger als die Pulspause zwischen den einzelnen Plasmapulsen innerhalb der Spuren, beziehungsweise Pulsserien.

Der Beschichtungsvorgang mit Gaswechsel weist folgenden zeitlichen Ablauf auf:

1. Füllen des Reaktors mit dem Reaktionsgas, z.B. HMDSO + $O_2$,

2. Zünden des Plasmas durch Einschalten der Mikrowelle -> Einbringen von Energie in das Gas. Dadurch werden Moleküle, insbesondere auch die Precursor-Moleküle in reaktive Bestandteile zerlegt. Die Bestandteile unterlaufen dann eine Reaktion und es erfolgt eine Kondensation der Reaktionsprodukte an allen zur Verfügung stehenden freien Oberflächen, insbesondere natürlich auf dem zu beschichtenden Werkstück, wie etwa vorzugsweise an der Innenseite eines Reflektors. Reaktionsprodukte, die nicht an freien Oberflächen kondensiert sind, werden abgepumpt.

3. Abpumpen und gleichzeitige Neubefüllung des Reaktorraums. Dieser Vorgang ist in seiner Dauer zeitlich abhängig vom Volumen des Reaktorraums, beispielsweise des konkaven Innenbereichs eines Reflektors und von der Höhe des Gasflusses. Die hierzu erforderliche Mindestzeit ist die in den Figuren 4 und 5 aufgetragene untere Gerade, d.h. diese Zeit ist die unter den gegebenen Bedingungen, insbesondere das Volumen des Reaktorraums und die Höhe des Gasflusses, mindestens benötigte Zeit für den einmaligen kompletten Gasaustausch.

Bei dem in Fig. 8B gezeigten Beispiel besitzt die Pulsdauer 91 (d.h. die MW-Energie ist "ein") i.a. Werte zwischen 0,6 und 1,2 ms, in Ausnahmefällen auch weniger oder mehr.

Die Pulpause 92 zwischen den einzelnen Pulsen (d.h. die MW-Energie ist "aus", das Gas fließt aber kontinuierlich weiter) ist erfindungsgemäß mindestens so lang, dass ein kompletter Gasaustausch im Reaktorvolumen stattfinden kann, sonst wird der Reflektor beim nächsten MW-Puls nur teilbeschichtet. Diese Pulspause ist in den Figuren 4 und 5 als Ordinate aufgetragen.

Da in vorteilhafter Weiterbildung der Erfindung über die Pulspause der Gesamteintrag der effektiven MW-Leistung und damit auch die während der Beschichtung entstehende Temperatur geregelt wird, kann die Pulspause auch deutlich länger als die für einen kompletten Gasaustausch benötigte Mindestzeit gewählt werden. Längere Pulspausen 92 haben sich insbesondere bei Beschichtungsprozessen auf Glaskeramik-Substraten als günstig erwiesen.

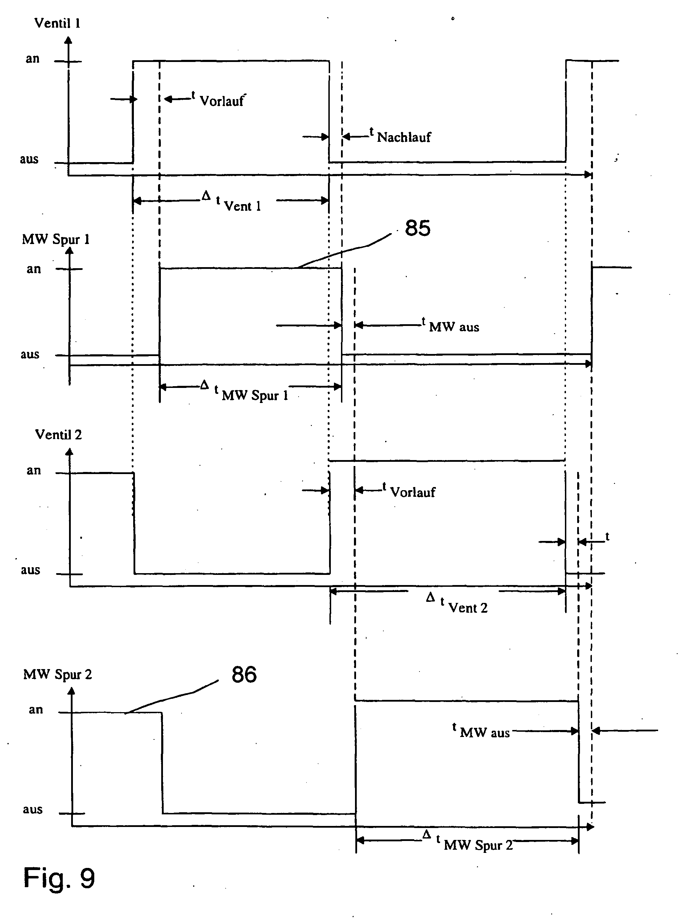

Im folgenden wird die Synchronisation der Plasma-Pulsserien, beziehungsweise Spuren und der Schaltung der Ventile bei einem Gaswechsel zwischen der Abscheidung zweier Lagen einer Wechselschicht anhand von Fig. 9 verdeutlicht. Unter einem Gaswechsel ist ein Wechsel zwischen zwei Precursorgasen zu verstehen, wie etwa ein Wechsel zwischen HMDSO + $O_2$ und $TiCl_4$ + $O_2$.

Die Beschichtungsanlage zur Durchführung des in Fig. 9 dargestellten Ablaufs entspricht dabei dem in Fig. 1 gezeigten Beispiel. Fig. 9 zeigt dazu vier Zeitdiagramme. Das oberste Zeitdiagramm ("Ventil 1") zeigt den zeitabhängigen Schaltzustand eines der Ventile 13, 15 der in Fig. 1 gezeigten Anordnung, das Diagramm "Ventil 2" den Schaltzustand des anderen der beiden Ventile. Die beiden anderen Diagramme zeigen die Schaltzustände der beiden Spuren, beziehungsweise Pulsserien 85, 86. Dem Ventil 1 ist dabei die Spur 85 und dem Ventil 2 die Spur 86 zugeordnet.

Dies bedeutet, daß mit dem durch Ventil 1 eingeleiteten Prozessgas eine Lage mittels der Prozessparameter der Spur 85 und mit dem durch Ventil 2 eingeleiteten Prozessgas eine Lage mittels der Prozessparameter der Spur 86 abgeschieden wird.

Die Zeit, die das Gas vom Ventil 1 bis zum Reaktionsvolumen wie beispielsweise das Volumen des konkaven Innenbereichs eines Reflektors braucht, ist die Vorlaufzeit $t_{vorlauf}$. Das Ventil wird geöffnet, nach der Vorlaufzeit wird die entsprechende Mikrowellenspur zugeschaltet.

Die Vorlauf- bzw. Nachlaufzeit ist im wesentlichen von der Geometrie der Beschichtungsanlage abhängig. Hier sind insbesondere Länge und Durchmesser der entsprechenden Leitungen vom Gasmischpunkt zu den einzelnen Reaktionsmodulen, wie sie in Fig. 2 zu sehen sind, zu nennen.

Die Vorlaufzeit ist im Idealfall gleich der Nachlaufzeit. In diesem Idealfall könnte die Quelle, wie beispielsweise eine Mikrowelle theoretisch die ganze Zeit hindurch aktiviert sein, also kontinuierlich im Pulsbetrieb Leistung in das Reaktorvolumen einkoppeln. Dabei würde lediglich zu bestimmten Zeitpunkten die Leistung der Quelle von den Einstellungen für die eine Spur auf die für die andere Spur umgeschaltet werden.

Es zeigt sich, daß dieses ist in der Praxis im allgemeinen aber nicht der Fall ist. Daher sind Vorlauf- und Nachlaufzeit $t_{Nachlauf}$ etwas unterschiedlich lang. Um an der Grenzfläche zwischen den Lagen keine ungewünschten Mischschichten abzuscheiden, wird daher in einer Zeitspanne "$t_{MW\ aus}$" die Quelle komplett ausgeschaltet. Diese Zeitspanne ist vorzugsweise durch den Betrag der Differenz der beiden Zeiten gegeben. Abweichend davon kann für die Zeitspanne "$t_{MW\ aus}$" eine Dauer zwischen $0,8 \times |t_{Vorlauf} - t_{Nachlauf}|$ und höchstens $5 \times |t_{Vorlauf} - t_{Nachlauf}|$ gewählt werden. Längere Dauern für "$t_{MW\ aus}$" können beispielsweise dann sinnvoll werden, wenn die Ventile 13, 15 nicht wie im Beispiel der Fig. 9 gleichzeitig, sondern mit einer kleinen Verzögerung geschaltet werden.

Da während der Zeitspanne "$t_{MW\ aus}$" keine Leistung eingekoppelt wird und damit auch keine Reaktionsprodukte entstehen und somit auch keine Beschichtung abgeschieden werden kann, sollte diese Zeitdauer im Sinne einer maximalen Beschichtungsleistung der Anlage möglichst kurz gehalten werden.

Es ist dem Fachmann ersichtlich, daß die Erfindung nicht auf die vorstehend beschriebenen beispielhaften Ausführungsformen beschränkt ist, sondern vielmehr in vielfältiger Weise variiert werden kann. Insbesondere können die Merkmale der einzelnen Ausführungsbeispiele auch miteinander kombiniert, einzelne Merkmale auch beispielsweise weggelassen werden.

**Patentansprüche**

1. Beschichtungsanlage zum Beschichten von Gegenständen mit Wechselschichten, vorzugsweise zum gleichzeitigen Beschichten mehrer Gegenstände mit Wechselschichten, umfassend

    zumindest eine Reaktionskammer (7), in welcher zu beschichtende Gegenstände anordenbar sind, oder eine Einrichtung, um mit einem zu beschichtenden Gegenstand eine Reaktionskammer zu bilden, eine gepulst betreibbare Quelle für elektromagnetische Energie, um im Reaktor ein gepulstes Plasma zu zünden,

    eine Zuführung für bei dem Beschichten verwendete Prozessgase, insbesondere für Precursorgase, welche durch eine Gaswechseleinrichtung (2) der Beschichtungsanlage in die Reaktionskammer einleitbar sind, wobei die Gaswechseleinrichtung zumindest einen Gasmischpunkt (11) umfasst, in welchen zumindest zwei mit Ventilen (13,15) versehene Zuleitungen (3,5) für verschiedene Precursor-Gase,

    sowie zumindest eine Zuleitung (17) für ein weiteres Gas, um dieses im Gasmischpunkt mit einem durch eines der Ventile (13,15) eingeleiteten Gase zur Erzeugung unterschiedlicher Prozessgas-Gemische zu mischen, sowie eine Ableitung zur Reaktionskammer münden, wobei die Zuleitung für ein weiteres Gas und die Ableitung zur Reaktionskammer in der Verbindung zwischen den beiden Ventilen angeschlossen sind, und wobei zu jeder der Zuleitungen für verschiedene Precursor-Gase jeweils eine mit einer Pumpeinrichtung verbundene Bypass-Leitung (25,27) vorgesehen ist, wobei in die Bypass-Leitungen jeweils ein weiteres Ventil (29,31) geschaltet ist, und wobei eine Steuereinrichtung für die Ventile und die Quelle vorgesehen ist, welche für einen Wechsel des Prozessgasgemischs zu einer Steuerung der Ventile in den Bypass-Leitungen und der Ventile der Zuleitungen für verschiedene Precursor-Gase derart ausgebildet ist, daß gleichzeitig das Ventil in der Zuleitung eines Precursorgases geschlossen und das Ventil in der BypassLeitung für dieses Precursorgas geöffnet wird, und umgekehrt das Ventil in der Zuleitung des anderen Precursorgases geöffnet und das Ventil in der BypassLeitung für dieses Precursorgas gleichzeitig geschlossen wird, **dadurch gekennzeichnet, daß** die Steuereinrichtung zur Einstellung des Zeitpunkts des Beginns einer Pulsserie zur Abscheidung einer Lage des Wechselschichtsystems in Abhängigkeit von der Schaltzeit der Ventile ausgebildet ist, wobei die Steuereinrichtung zur Einstellung einer Pause mit einer Dauer von mindestens $0,8 \times |t_{vorlauf} - t_{Nachlauf}|$ und höchstens $5 \times |t_{Vorlauf} - t_{Nachlauf}|$ zwischen Pulsserien ausgebildet ist, wobei $t_{vorlauf}$ die Zeitdauer bezeichnet, welche das Gas benötigt, um vom Gasmischpunkt bis zur Reaktionskammer zu gelangen und wobei $t_{Nachlauf}$ die Zeitdauer bezeichnet, welche für die Entleerung des vorher in der Reaktionskammer befindlichen Prozessgasgemisches benötigt wird.

2. Beschichtungsanlage gemäß dem vorstehenden Anspruch, **dadurch gekennzeichnet, daß** die Steuereinrichtung derart zur Steuerung der Quelle ausgebildet ist, daß eine Pulsserie zur Abscheidung einer Lage des Wechselschichtsystems jeweils zu einem Zeitpunkt gestartet wird, der um eine Dauer T verzögert ist zum Schaltzeitpunkt der zugeordneten Ventile für das jeweilige Prozessgasgemisch zur Abscheidung einer Lage des Wechselschichtsystems in der Zuleitung, wobei die Dauer T zumindest $0,8 \times t_{volauf}$ und höchstens $50 \times t_{vorlauf}$ beträgt.

3. Beschichtungsanlage gemäß Anspruche 1 oder 2 , **dadurch gekennzeichnet, daß** eine Regeleinrichtung vorgesehen ist, um den Druck in den Bypass-Leitungen an den Druck im Gasmischpunkt anzupassen.

4. Beschichtungsanlage gemäß dem vorstehenden Anspruch, **dadurch gekennzeichnet, daß** die Regeleinrichtung zur Anpassung des Drucks in den Bypass-Leitungen an den Druck im Gasmischpunkt auf eine Druckdifferenz, die kleiner als 20% des Drucks im Gasmischpunkt ist, vorgesehen ist.

5. Beschichtungsanlage gemäß einem der vorstehenden Ansprüche, **gekennzeichnet durch** eine Regeleinrichtung, mit welcher ein Druckabfall entlang der Zuleitungen beim Einspeisen der Gase in den Gasmischpunkt um mehr als einen Faktor zwei aufrechterhalten werden kann oder eine stellbar ist.

6. Beschichtungsanlage gemäß einem der vorstehenden Ansprüche , **dadurch gekennzeichnet, daß** der Gasmischpunkt Bestandteil einer Mischpunktventil-Einheit ist, welche zwei Ventile umfasst, die an zwei Zuleitungen für verschiedene Precursor-Gase eines Prozessgasgemischs angeschlossen sind, sowie zumindest eine Zuleitung für ein weiteres Gas, um dieses im Gasmischpunkt mit einem durch eines der Ventile eingeleiteten Gase zu mischen, und eine Ableitung zur Reaktionskammer, wobei die Zuleitung für ein weiteres Gas und die Ableitung zur Reaktionskammer in der Verbindung zwischen den beiden Ventilen angeschlossen sind.

7. Beschichtungsanlage gemäß dem vorstehenden Anspruch, **dadurch gekennzeichnet, daß** die Ventilsitze der beiden Ventile in einem gemeinsamen Ventilblock zusammengefasst sind.

8. Beschichtungsanlage gemäß einem der beiden vorstehenden Ansprüche, **dadurch gekennzeichnet, daß** die Verbindung jeweils zwischen den Ventilsitzen der beiden Ventile zur Mitte des Gasmischpunkts kleiner ist als 1/10 der Länge der Ableitung vom Gasmischpunkt bis zur Reaktionskammer.

9. Beschichtungsanlage nach einem der vorstehenden Ansprüche ,**dadurch gekennzeichnet, daß** die Steuereinrichtung zur Steuerung der Quelle zur Abgabe zeitlich beabstandeter Pulse mit einer Dauer der Länge D und einer Pause der Länge P zwischen den Pulsen ausgebildet ist , wobei für die Plasmapulse gilt, daß die Pulspause P in Millisekunden zwischen zwei zeitlich benachbarten Pulsen länger ist als $P_{min}$[ms]=2,5 + 0,05*V, vorzugsweise $P_{min}$[ms]=2,5 + 0,055*V, wobei V das Beschichtungsvolumen in der Reaktionskammer in Milliliter und $P_{min}$[ms] eine Zeitdauer in Millisekunden bezeichnen.

10. Beschichtungsanlage gemäß dem vorstehenden Anspruch, **dadurch gekennzeichnet, daß** die Steuereinrichtung eingerichtet ist, die Quelle so zu steuern, daß die Pause P zwischen den Plasmapulsen eine Dauer hat, die länger ist als

$$P_{min}[ms]=10 + 0,133*V,$$

wobei $P_{min}$[ms] eine Zeitdauer in Millisekunden und V das Beschichtungsvolumen in der Reaktionskammer in Milliliter bezeichnen.

11. Beschichtungsanlage gemäß 9 oder 10, **dadurch gekennzeichnet, daß** die Steuereinrichtung eingerichtet ist, die Pause zwischen zwei Plasmapulsen kürzer einzustellen, als
P[ms]= P[ms]=80 + 0,05*V, vorzugsweise P[ms]= P[ms]=60 + 0,05*V, besonders bevorzugt P[ms]= P[ms]=50 + 0,05*V wobei P[ms] eine Zeitdauer in Millisekunden und V das Beschichtungsvolumen in der Reaktionskammer in Milliliter bezeichnen.

12. Beschichtungsanlage gemäß einem der
Ansprüche 9 bis 11, **dadurch gekennzeichnet, daß** die Steuereinrichtung eingerichtet ist, die Quelle so zu steuern, daß die Pause P zwischen den Plasmapulsen mindestens eine Dauer hat, die gegeben ist durch:

$$P[ms] = max( 2,5 + 0,05*V, V \cdot [(1/6) \cdot exp(-V/300) + (1/20)]),$$

wobei $P_{min}$[ms] eine Zeitdauer in Millisekunden und V das Beschichtungsvolumen in der Reaktionskammer in Milliliter bezeichnen.

13. Beschichtungsanlage gemäß einem der vorstehenden Ansprüche, , **dadurch gekennzeichnet, daß** die Ableitung zur Reaktionskammer eine Umwegleitung (33) umfasst, welche mit mehreren Umlenkungen zur Reaktionskammer verläuft und/oder Hindernisse in der Ableitung umfasst, die zu Verwirbelungen des Gasstroms führen, so daß eine turbulente Vermischung der im Gasmischpunkt miteinander in Kontakt gebrachten Gase erfolgt.

14. Beschichtungsanlage gemäß einem der vorstehenden Ansprüche, **gekennzeichnet durch** mehrere Reaktionskammern, in welcher zu beschichtende Gegenstände anordenbar sind, oder Einrichtungen, um mit zu beschichtenden Gegenständen Reaktionskammern zu bilden, eine Gaszuführungseinrichtung mit einer Ableitung zu den Reaktionskammern und eine Einrichtung zur Einstrahlung elektromagnetischer Energie, um ein Plasma im vom Prozessgas ausgefüllten Bereich in den Reaktionskammern zu zünden, wobei die Ableitung in mehrere Abzweige (38-41) aufgeteilt ist, welche jeweils an eine Reaktionskammer angeschlossen sind, wobei von einer Leitung des Leitungssystems mit der Ableitung der Gaszuführungseinrichtung und den Abzweigungen von einer Leitung jeweils genau zwei Abzweige abgehen, so daß die Ableitung in $2^n$, n=2, 3, ... Abzweigleitungen aufgespalten ist und die Zuleitungen zu jeder Kammer gleich oft aufgeteilt sind.

15. Beschichtungsanlage gemäß einem der beiden Anspruche 14, **dadurch gekennzeichnet, daß** die Abzweigleitungen in einer Ebene von der Ableitung abzweigen.

16. Beschichtungsanlage gemäß dem vorstehenden Anspruch, **dadurch gekennzeichnet, daß** die Beschichtungsanlage mehrere Gasmischpunkte aufweist, die entlang einer Richtung quer zur Ebene, in welcher die Abzweigleitungen liegen, angeordnet sind.

17. Beschichtungsanlage gemäß einem der vorstehenden Ansprüche, **gekennzeichnet durch** einer Spektrometeranordnug (64) zur zeitaufgelösten Erfassung von Emissionslinien und/oder Spektren, welche bei der Beschichtung innerhalb der Reaktionskammer entstehen.

18. Beschichtungsanlag gemäß einem der vorstehenden Ansprüche, **gekennzeichnet durch** eine Einrichtung zur Erfassung der Pulszugformen von Precursorgasen, insbesondere zur Messung deren zeitlicher Dichteverläufe und Geschwindigkeiten.

19. Beschichtungsanlage gemäß dem vorstehenden Anspruch, **dadurch gekennzeichnet, daß** die Einrichtung zur Erfassung der Pulszugformen von Precursorgasen eine optische Spektrometeranordnung zur Erfassung von Fluoreszenzund/oder Absorptionslinien umfasst.

20. Verfahren zum Beschichten von Gegenständen mit Wechselschichten in einer Beschichtungsanlage, insbesondere in einer Beschichtungsanlage gemäß einem der vorstehenden Ansprüche, vorzugsweise zum gleichzeitigen Beschichten mehrerer Gegenstände mit Wechselschichten, wobei in zumindest einer Reaktionskammer ein zu beschichtender Gegenstand angeordnet oder eine Reaktionskammer mit einem zu beschichtenden Gegenstand gebildet wird, zumindest ein Beschichtungsbereich der Reaktionskammer evakuiert, und nacheinander verschiedene Prozessgase in den Beschichtungsbereich geleitet und ein gepulstes Plasma mittels einer gepulst betriebenen Quelle elektromagnetischer Energie zur Abscheidung gezündet wird, wodurch ein Schichtsystem mit Lagen unterschiedlicher Zusammensetzung auf dem Gegenstand abgeschieden wird, wobei das Einleiten der Prozessgase in die Reaktionskammer mittels einer Gaswechseleinrichtung erfolgt, wobei die Gaswechseleinrichtung zumindest einen Gasmischpunkt umfasst, in welchen zumindest zwei mit Ventilen versehene Zuleitungen für verschiedene Precursor-Gase,
sowie zumindest eine Zuleitung für ein weiteres Gas münden, wobei dieses weitere Gas im Gasmischpunkt mit jeweils einem der durch eines der Ventile eingeleiteten Gase gemischt wird und durch eine Ableitung zur Reaktionskammer abgeführt wird, wobei die Zuleitung für ein weiteres Gas und die Ableitung zur Reaktionskammer in der Verbindung zwischen den beiden Ventilen angeschlossen sind, und wobei zu jeder der Zuleitungen für verschiedene Precursor-Gase jeweils eine mit einer Pumpeinrichtung verbundene Bypass-Leitung vorgesehen ist, wobei in die Bypass-Leitungen jeweils ein weiteres Ventil geschaltet ist, und wobei das Prozessgasgemisch gewechselt wird, indem die Ventile in den Bypass-Leitungen und die Ventile der Zuleitungen für verschiedene Precursor-Gase so geschaltet werden, daß gleichzeitig das Ventil in der Zuleitung eines Precursorgases geschlossen, das Ventil in der BypassLeitung für dieses Precursorgas geöffnet und umgekehrt das Ventil in der Zuleitung des anderen Precursorgases geöffnet und das Ventil in der Bypass-Leitung für dieses Precursorgas gleichzeitig geschlossen wird, wobei jeweils eine Lage der Wechselschicht mittels einer Pulsserie von Plasmapulsenabgeschieden wird, den Zeitpunkt des Beginns einer Pulsserie zur Abscheidung einer Lage des Wechselschichtsystems in Abhängigkeit von der Schaltzeit der Ventile einstellt, und wobei zwischen den Pulsserien zur Abscheidung aufeinanderfolgender Lagen eine Pause mit einer Dauer von mindestens $0,8 \times |t_{vorlauf} - t_{Nachlauf}|$ und höchstens $5 \times |t_{vorlauf} - t_{Nachlauf}|$ eingestellt wird, wobei $t_{vorlauf}$ die Zeitdauer bezeichnet, welche das Gas benötigt, um vom Gasmischpunkt bis zur Reaktionskammer zu gelangen und wobei $t_{Nachlauf}$ die Zeitdauer bezeichnet, welche für die Entleerung des vorher in der Reaktionskammer befindlichen Prozessgasgemisches benötigt wird.

21. Verfahren gemäß dem vorstehenden Anspruch, **dadurch gekennzeichnet, daß** die Quelle so gesteuert wird, daß eine Pulsserie zur Abscheidung einer Lage des Wechselschichtsystems jeweils zu einem Zeitpunkt gestartet wird, der um eine Dauer T verzögert ist zum Schaltzeitpunkt der zugeordneten Ventile für das jeweilige Prozessgasgemisch zur Abscheidung einer Lage des Wechselschichtsystems in der Zuleitung, wobei die Dauer T zumindest $0,8 \times t_{vorlauf}$ und höchstens $50 \times t_{vorlauf}$ beträgt.

22. Verfahren gemäß einem der beiden vorstehenden Ansprüche, **dadurch gekennzeichnet, daß** mittels einer Regeleinrichtung der Druck in den Bypass-Leitungen an den Druck im Gasmischpunkt angepasst wird.

23. Verfahren gemäß dem vorstehenden Anspruch, **dadurch gekennzeichnet, daß** der Druck in den BypassLeitungen an den Druck im Gasmischpunkt auf eine Druckdifferenz angepasst wird, die kleiner als 20% des Drucks im Gasmischpunkt beträgt.

24. Verfahren gemäß einem der Ansprüche 20 bis 23, **dadurch gekennzeichnet, daß** die Gase in einer Mischpunktventil-Einheit gemischt werden, bei welcher die Ventilsitze der beiden Ventile in einem gemeinsamen Ventilblock zusammengefasst sind.

25. Verfahren gemäß einem der Ansprüche 20 bis 24, **dadurch gekennzeichnet, daß** im Mischpunkt Sauerstoff mit zumindest einem Precursor gemischt wird.

26. Verfahren gemäß einem der Ansprüche 20 bis 25, , **dadurch gekennzeichnet, daß** eine Steuereinrichtung die Quelle so steuert, daß die Plasmapulse in der Reaktionskammer mit einer Dauer der Länge D und einer Pause der Länge P zwischen den Pulsen erzeugt werden, wobei für die Plasmapulse gilt, daß die Pulspause P in Millisekunden zwischen zwei zeitlich benachbarten Pulsen länger ist, als $P_{min}[ms]=2,5 + 0,05*V$, vorzugsweise $P_{min}[ms]=2,5 + 0,055*V$, wobei V das Beschichtungsvolumen in der Reaktionskammer in Millilitern und $P_{min}[ms]$ eine Zeitdauer in Millisekunden bezeichnen.

27. Verfahren gemäß dem vorstehenden Anspruch, **dadurch gekennzeichnet, daß** die Pause P länger eingestellt wird, als

$$P[ms]=10 + 0,133*V,$$

wobei P[ms] eine Zeitdauer in Millisekunden und V das Beschichtungsvolumen in der Reaktionskammer in Millilitern bezeichnen.

28. Verfahren gemäß Anspruche 26 oder 27, **dadurch gekennzeichnet, daß** die Pause P zwischen zwei zeitlich benachbarten Pulsen länger eingestellt wird, als

$$P[ms] = max( 2,5 + 0,05*V, V \cdot [(1/6) \cdot exp(-V/300) + (1/20)])$$

wobei $P_{min}[ms]$ eine Zeitdauer in Millisekunden und V das Beschichtungsvolumen in der Reaktionskammer in Millilitern bezeichnen

29. Verfahren gemäß einem der Ansprüche 26 bis 28, **dadurch gekennzeichnet, daß** die Pause kürzer eingestellt wird, als
P[ms]= 80 + 0,05*V, vorzugsweise P[ms]= 60 + 0,05*V, besonders bevorzugt P[ms]= 50 + 0,05*V,
wobei P[ms] eine Zeitdauer in Millisekunden und V das Beschichtungsvolumen in der Reaktionskammer in Millilitern bezeichnen.

30. Verfahren gemäß einem der Ansprüche 20 bis 29, **dadurch gekennzeichnet, daß** die im Gasmischpunkt miteinander in Kontakt gebrachten Gase über eine Umwegleitung zur Reaktionskammer abgeleitet werden welche Umwegleitung mit mehreren Umlenkungen zur Reaktionskammer verläuft und/oder Hindernisse in der Ableitung umfasst, wobei der Gasstrom der im Gasmischpunkt miteinander in Kontakt gebrachten Gase in der Umwegleitung an den Umlenkungen und/oder an den Hindernissen so verwirbelt wird , daß eine turbulente Vermischung der Gase erfolgt.

31. Verfahren
gemäß einem der Ansprüche 20 bis 30, **dadurch gekennzeichnet, daß** mehrere zu beschichtende Gegenstände in mehreren Reaktionskammern angeordnet oder Reaktionskammerm mit zu beschichtenden Gegenständen gebildet werden, zumindest die Beschichtungsbereiche der Reaktionskammern evakuiert und Prozessgas in die Beschichtungsbereiche geleitet und ein Plasma zur Abscheidung gezündet wird, so daß eine Beschichtung abgeschieden wird, wobei das Einleiten der Prozessgase in die Reaktionskammern mittels einer von einem Gasmischpunkt ausgehenden Ableitung erfolgt,
wobei verschiedene Gase des Prozessgases im Mischpunkt gemischt werden und der Gasstrom über die Ableitung in $2^n$, n=2, 3, ... Abzweige in entsprechend viele Teilströme aufgeteilt wird, welche jeweils in eine Reaktionskammer geleitet werden, wobei jeder Teilstrom gleich oft aus dem Gasstrom herausgeteilt wird und bei jeder Teilung der Gasstrom in genau zwei Teilströme geteilt wird.

32. Verfahren gemäß Anspruch 31, **dadurch gekennzeichnet, daß** die Teilströme in einem von der Ableitung abgezweigten Abzweig herausgeteilt werden.

**Claims**

1. Coating system for coating articles with alternating layers, preferably for simultaneously coating a plurality of articles with alternating layers, comprising
at least one reaction chamber (7), in which articles to be coated can be arranged, or a device, in order to form a reaction chamber with an article to be coated, a source for electromagnetic energy which can be operated in a pulsed fashion in order to ignite a pulsed plasma in the reactor,
a feed for process gases used during coating, in particular precursor gases, which can be introduced into the reaction chamber by a gas exchanging device (2) of the coating system, wherein the gas exchanging device comprises at least one gas mixing point (11), into which issue at least two supply lines (3, 5), provided with valves (13, 15), for various precursor gases,
and at least one supply line (17) for a further gas in order to mix the latter in the gas mixing point with a gas introduced through one of the valves (13, 15) to produce different process gas mixtures, as well as a discharge line to the reaction chamber,
wherein the supply line for a further gas and the discharge line to the reaction chamber are connected in the connection between the two valves, and wherein in each case a bypass line (25, 27) connected to a pumping device is provided with respect to each of the supply lines for various precursor gases, wherein in each case a further valve (29, 31) is connected into the bypass lines, and wherein a control device is provided for the valves and the source and, in order to exchange the process gas mixture, the control device is formed for controlling the valves in the bypass lines and the valves of the supply lines for various precursor gases such that at the same time the valve in the supply line of a precursor gas is closed and the valve in the bypass line for this precursor gas is opened, and conversely the valve in the supply line of the other precursor gas is opened and the valve in the bypass line for this precursor gas is simultaneously closed, **characterised in that** the control device is formed for setting the point in time of the beginning of a pulse series for depositing a layer of the alternating layer system as a function of the switching time of the valves, wherein the control device is formed for setting, between pulse series, a pause with a duration of at least $0.8 \text{ X } | t_{advance} - t_{follow-up} |$ and at most $5 \text{ x } | t_{advance} - t_{follow-u}p |$, wherein $t_{advance}$ designates the time duration required for the gas to pass from the gas mixing point to the reaction chamber, and wherein $t_{follow-up}$ designates the time duration required to empty the process gas mixture previously located in the reaction chamber.

2. Coating system as claimed in the preceding claim, **characterised in that** the control device is formed for controlling the source such that a pulse series for depositing a layer of the alternating layer system is started in each case at a point in time which is delayed by a duration T with respect to the switching time of the assigned valves for the respective process gas mixture for depositing a layer of the alternating layer system in the supply line, wherein the duration T is at least 0.8 x advance and at most $50 \text{ x } t_{advance}$.

3. Coating system as claimed in claim 1 or 2, **characterised in that** a regulating device is provided is provided in order to adapt the pressure in the bypass lines to the pressure in the gas mixing point.

4. Coating system as claimed in the preceding claim, **characterised in that** the regulating device is provided for adapting the pressure in the bypass lines to the pressure in the gas mixing point to a pressure difference which is less than 20% of the pressure in the gas mixing point.

5. Coating system as claimed in any one of the preceding claims, **characterised by** a regulating device, by means of which a pressure drop along the supply lines as the gases are being fed into the gas mixing point can be maintained or set by a factor of more than two.

6. Coating system as claimed in any one of the preceding claims, **characterised in that** the gas mixing point is a component of a mixing point valve unit which comprises two valves which are connected to two supply lines for various precursor gases of a process gas mixture, as well as at least one supply line for a further gas, in order to mix the latter in the gas mixing point with a gas introduced through one of the valves, and a discharge line to the reaction chamber, wherein the supply line for a further gas and the discharge line to the reaction chamber are connected in the connection between the two valves.

7. Coating system as claimed in the preceding claim, **characterised in that** the valve seats of the two valves are combined in a common valve block.

8. Coating system as claimed in any one of the two preceding claims, **characterised in that** the connection between the valve seats of the two valves to the middle of the gas mixing point is in each case smaller than 1/10 of the length of the discharge line from the gas mixing point to the reaction chamber.

9. Coating system as claimed in any one of the preceding claims, **characterised in that** the control device is formed for controlling the source for outputting temporally spaced pulses with a duration of length D and a pause of length P between the pulses, wherein for the plasma pulses the pulse pause P in milliseconds between two temporally adjacent pulses is longer than $P_{min}$ [ms] = 2.5 + 0.05*V, preferably $P_{min}$ [ms] = 2.5 + 0.055*V, wherein V designates the coating volume in the reaction chamber in millilitres and $P_{min}$ [ms] designates a time duration in milliseconds.

10. Coating system as claimed in the preceding claim, **characterised in that** the control device is arranged to control the source such that the pause P between the plasma pulses is of a duration which is longer than

$$P_{min} \text{ [ms]} = 10 + 0.133*V,$$

wherein $P_{min}$ [ms] designates a time duration in milliseconds and V designates the coating volume in the reaction chamber in millilitres.

11. Coating system as claimed in claims 9 or 10, **characterised in that** the control device is arranged to set the pause between two plasma pulses to be shorter than P[ms] = P[ms] = 80 + 0.05*V, preferably P[ms] = P[ms] = 60 + 0.05*V, particularly preferably P[ms] = P[ms] = 50 + 0.05*V, wherein P[ms] designates a time duration in milliseconds and V designates the coating volume in the reaction chamber in millilitres.

12. Coating system as claimed in any one of claims 9 to 11, **characterised in that** the control device is arranged to control the source so that the pause P between the plasma pulses is at least of a duration which is specified by:

$$P[ms] = \max (2.5 + 0.05*V, V \cdot [(1/6) \cdot \exp(-V/300) + (1/20)]),$$

wherein $P_{min}$ [ms] designates a time duration in milliseconds and V designates the coating volume in the reaction chamber in millilitres.

13. Coating system as claimed in any one of the preceding claims, **characterised in that** the discharge line to the reaction chamber comprises a detour line (33) which runs with a plurality of diversions to the reaction chamber and/or comprises obstacles in the discharge line which produce swirling in the gas flow such that turbulent mixing of the gases brought into contact with one another in the gas mixing point occurs.

14. Coating system as claimed in any one of the preceding claims, **characterised by** a plurality of reaction chambers, in which articles to be coated can be arranged, or devices in order to form reaction chambers with articles to be coated, a gas feeding device having a discharge line to the reaction chambers, and a device for irradiating electromagnetic energy in order to ignite a plasma in the region filled by the process gas in the reaction chambers, wherein the discharge line is divided up into a plurality of branches (38-41) which are each connected to a reaction chamber, wherein exactly two branches lead off in each case from one line of the line system with the discharge line of the gas feeding device and the branches of a line such that the discharge line is split into $2^n$, n = 2, 3, ... branch lines, and the supply lines for each chamber are divided up equally often.

15. Coating system as claimed in claim 14, **characterised in that** the branch lines branch off from the discharge line in a plane.

16. Coating system as claimed in the preceding claim, **characterised in that** the coating system comprises a plurality of gas mixing points which are arranged in a direction transverse to the plane in which the branch lines lie.

17. Coating system as claimed in any one of the preceding claims, **characterised by** a spectrometer arrangement (64) for time-resolved acquisition of emission lines and/or spectra which are produced during coating inside the reaction chamber.

18. Coating system as claimed in any one of the preceding claims, **characterised by** a device for acquiring the pulse train shapes of precursor gases, in particular for measuring the temporal density progressions and velocities thereof.

19. Coating system as claimed in the preceding claim, **characterised in that** the device for acquiring the pulse train shapes of precursor gases comprises an optical spectrometer arrangement for acquiring fluorescence and/or absorption lines.

20. Method of coating articles with alternating layers in a coating system, in particular in a coating system as claimed in any one of the preceding claims, preferably for simultaneously coating a plurality of articles with alternating layers, wherein an article to be coated is arranged in at least one reaction chamber, or a reaction chamber is formed with an article to be coated,

at least one coating region of the reaction chamber is evacuated, and various process gases are guided sequentially into the coating region, and a pulsed plasma for deposition is ignited by means of a source of electromagnetic energy which is operated in a pulsed fashion, whereby a layer system having layers of different composition is deposited on the article, wherein the introduction of the process gases into the reaction chamber is performed by means of a gas exchanging device, wherein the gas exchanging device comprises at least one gas mixing point into which issue at least two supply lines, provided with valves, for various precursor gases,

and at least one supply line for a further gas, wherein this further gas is mixed in the gas mixing point in each case with one of the gases introduced through one of the valves and is carried away by a discharge line to the reaction chamber, wherein the supply line for a further gas and the discharge line to the reaction chamber are connected in the connection between the two valves, and wherein in each case a bypass line connected to a pumping device is provided with respect to each of the supply lines for various precursor gases, wherein in each case a further valve is connected into the bypass lines, and wherein the process gas mixture is exchanged by switching the valves in the bypass lines and the valves of the supply lines for various precursor gases such that simultaneously the valve in the supply line of a precursor gas is closed, the valve in the bypass line for this precursor gas is opened, and conversely the valve in the supply line of the other precursor gas is opened and the valve in the bypass line for this precursor gas is simultaneously closed, wherein in each case a layer of the alternating layer is deposited by means of a pulse series of plasma pulses, the point in time of the beginning of a pulse series for depositing a layer of the alternating layer system is set as a function of the switching time of the valves, and wherein between the pulse series for depositing consecutive layers a pause is set with a duration of at least $0.8 \times | t_{advance} - t_{follow-up} |$ and at most $5 \times | t_{advance} - t_{follow-up} |$, wherein $t_{advance}$ designates the time duration required for the gas to pass from the gas mixing point to the reaction chamber, and wherein $t_{follow-up}$ designates the time duration required to empty the process gas mixture previously located in the reaction chamber.

21. Method as claimed in the preceding claim, **characterised in that** the source is controlled such that a pulse series for depositing a layer of the alternating layer system is started in each case at a point in time which is delayed by a duration T with respect to the switching time of the assigned valves for the respective process gas mixture for depositing a layer of the alternating layer system in the supply line, wherein the duration T is at least $0.8 \times t_{advance}$ and at most $50 \times t_{advance}$.

22. Method as claimed in any one of the two preceding claims, **characterised in that** by means of a regulating device the pressure in the bypass lines is adapted to the pressure in the gas mixing point.

23. Method as claimed in the preceding claim, **characterised in that** the pressure in the bypass lines is adapted to the pressure in the gas mixing point to a pressure difference which is less than 20% of the pressure in the gas mixing point.

24. Method as claimed in any one of claims 20 to 23, **characterised in that** the gases are mixed in a mixing point valve unit in which the valve seats of the two valves are combined in a common valve block.

25. Method as claimed in any one of claims 20 to 24, **characterised in that** in the mixing point oxygen is mixed with at least one precursor.

26. Method as claimed in any one of claims 20 to 25, **characterised in that** a control device controls the source such that the plasma pulses are produced in the reaction chamber with a duration of length D and a pause of length P between the pulses,

wherein for the plasma pulses the pulse pause P in milliseconds between two temporally adjacent pulses is longer than $P_{min}$ [ms] = 2.5 + 0.05*V, preferably $P_{mm}$ [ms] = 2.5 + 0.055*V, wherein V designates the coating volume in the reaction chamber in millilitres and $P_{min}$ [ms] designates a time duration in milliseconds.

27. Method as claimed in the preceding claim, **characterised in that** the pause P is set to be longer than

$$P[ms] = 10 + 0.133 * V,$$

wherein P[ms] designates a time duration in milliseconds and V designates the coating volume in the reaction chamber in millilitres.

28. Method as claimed in claim 26 or 27, **characterised in that** the pause P between two temporally adjacent pulses is set to be longer than $P[ms] = max\ (2.5 + 0.05 * V,\ V \cdot [(1/6) \cdot exp(-V/300) + (1/20)]),$ wherein $P_{min}$ [ms] designates a time duration in milliseconds and V designates the coating volume in the reaction chamber in millilitres.

29. Method as claimed in any one of claims 26 to 28, **characterised in that** the pause is set to be shorter than P[ms] = 80 + 0.05*V, preferably P[ms] = 60 + 0.05*V, particularly preferably P[ms] = 50 + 0.05*V, wherein P[ms] designates a time duration in milliseconds and V designates the coating volume in the reaction chamber in millilitres.

30. Method as claimed in any one of claims 20 to 29, **characterised in that** the gases brought into contact with one another in the gas mixing point are discharged via a detour line to the reaction chamber, which detour line runs with a plurality of diversions to the reaction chamber and/or comprises obstacles in the discharge line, wherein the gas flow of the gases brought into contact with one another in the gas mixing point are swirled in the detour line at the diversions and/or at the obstacles such that turbulent mixing of the gases occurs.

31. Method as claimed in any one of claims 20 to 30, **characterised in that** a plurality of articles to be coated are arranged in a plurality of reaction chambers or reaction chambers are formed with articles to be coated, at least the coating regions of the reaction chambers are evacuated and process gas is guided into the coating regions and a plasma for deposition is ignited, so that a coating is deposited, wherein the process gases are introduced into the reaction chambers by means of a discharge line which issues from a gas mixing point, wherein various gases of the process gas are mixed in the mixing point and the gas flow is divided up via the discharge line into $2^n$, n = 2, 3, ... branches into a corresponding plurality of partial flows which are each guided into a reaction chamber, wherein each partial flow is distributed equally often from the gas flow and for each division the gas flow is divided into precisely two partial flows.

32. Method as claimed in claim 31, **characterised in that** the partial flows are distributed in a branch which is branched off from the discharge line.

**Revendications**

1. Installation de revêtement destinée au revêtement d'objets avec des couches alternées, de préférence pour le revêtement simultané de plusieurs objets avec des couches alternées, comprenant :

au moins une chambre de réaction (7), dans laquelle des objets à revêtir peuvent être disposés, ou un dispositif pour former une chambre de réaction avec un objet à revêtir, une source pouvant être utilisée de façon pulsée pour de l'énergie électromagnétique, afin d'allumer un plasma pulsé dans le réacteur,
une arrivée pour des gaz de procédé utilisés lors du revêtement, en particulier pour des gaz précurseurs, qui peuvent être introduits par un dispositif de remplacement de gaz (2) de l'installation de revêtement dans la chambre de réaction, le dispositif de remplacement de gaz comprenant au moins un point de mélange de gaz (11), dans lequel débouchent au moins deux conduites d'arrivée (3, 5) dotées de soupapes (13, 15) pour différents gaz précurseurs, et au moins une conduite d'arrivée (17) pour un autre gaz, afin de mélanger ce gaz au point de mélange - de gaz avec un gaz introduit par l'une des soupapes (13, 16) pour générer différents mélanges de gaz de procédé, et une dérivation vers la chambre de réaction, la conduite d'arrivée pour un autre gaz et la dérivation vers la chambre de réaction étant raccordées dans la liaison entre les deux soupapes, et à chaque fois une conduite de bypass (25, 27) reliée à un dispositif de pompage étant prévue pour chacune des conduites d'arrivée pour différents gaz précurseurs, à chaque fois une autre soupape (29, 31) étant branchée sur les conduites de bypass, et un dispositif de commande étant prévu pour les soupapes et la source, laquelle est conçue pour un remplacement du mélange de gaz de procédé allant à une commande des soupapes dans les conduites de by-pass et des soupapes des arrivées pour différents gaz précurseurs, de telle sorte qu'en même temps la soupape dans la conduite d'arrivée d'un gaz précurseur est fermée et la soupape dans la conduite de by-pass pour ce gaz précurseur est ouverte, et inversement la soupape dans la conduite d'arrivée de l'autre gaz précurseur est ouverte et la soupape dans la conduite de by-pass pour ce gaz précurseur est simultanément fermée, **caractérisée en ce que** le dispositif de commande pour le réglage du moment du début d'une série d'impulsions est conçu pour la séparation d'une position du système de couches alternées en fonction du temps de commutation des soupapes, le dispositif de commande étant conçu pour le réglage d'une pause avec une durée d'au moins $0,8 \times |t_{Vorlauf} - t_{Nachlauf}|$ et au maximum $5 \times |t_{Vorlauf} - t_{Nachlauf}|$ entre les séries d'impulsions, $t_{Vorlauf}$ désignant la durée dont le gaz a besoin pour aller du point de mélange de gaz à la chambre de réaction et $t_{Nachlauf}$ désignant le temps qui est utilisé pour le vidage du mélange de gaz de procédé se trouvant auparavant dans la chambre de réaction.

2. Installation de revêtement selon la revendication précédente, **caractérisée en ce que** le dispositif de commande est conçu pour la commande de la source, de telle sorte qu'une série d'impulsions est démarrée pour la séparation d'une position du système de couches alternées à chaque fois à un moment qui est retardé d'une durée T par rapport au moment de commutation des soupapes attribuées pour le mélange respectif de gaz de procédé pour la séparation d'une position du système de couches alternées dans la conduite d'arrivée, la durée T étant au moins $0,8 \times t_{vorlauf}$ et au maximum $50 \times t_{Vorlauf}$.

3. Installation de revêtement selon la revendication 1 ou 2, **caractérisée en ce qu'**un dispositif de réglage est prévu pour adapter la pression dans les conduites de by-pass à la pression au point de mélange de gaz.

4. Installation de revêtement selon la revendication précédente, **caractérisée en ce que** le dispositif de réglage est prévu pour l'adaptation de la pression dans les conduites de by-pass à la pression au point de mélange de gaz à une différence de pression qui est inférieure à 20 % de la pression au point de mélange de gaz.

5. Installation de revêtement selon l'une des revendications précédentes, **caractérisée par** un dispositif de réglage, avec lequel une chute de pression le long des conduites d'arrivée lors de l'injection des gaz au point de mélange de gaz peut être maintenue ou réglée de plus d'un facteur deux.

6. Installation de revêtement selon l'une des revendications précédentes, **caractérisée en ce que** le point de mélange de gaz fait partie d'une unité de soupape de point de mélange, qui comprend deux soupapes, lesquelles sont raccordées à deux conduites d'arrivée pour différents gaz précurseurs d'un mélange de gaz de procédé, et au moins une conduite d'arrivée pour un autre gaz, afin de mélanger ce gaz au point de mélange de gaz avec un gaz introduit par l'une des soupapes, et une dérivation vers la chambre de réaction, la conduite d'arrivée pour un autre gaz et la dérivation vers la chambre de réaction étant raccordées dans la liaison entre les deux soupapes.

7. Installation de revêtement selon la revendication précédente, **caractérisée en ce que** les sièges de soupape des deux soupapes sont regroupés dans un bloc de soupapes commun.

8. Installation de revêtement selon l'une des deux revendications précédentes, **caractérisée en ce que** la liaison respectivement entre les sièges de soupape des deux soupapes avec le centre du point de mélange de gaz est inférieure à 1/10 de la longueur de la dérivation allant du point de mélange de gaz à la chambre de réaction.

9. Installation de revêtement selon l'une des revendications précédentes, **caractérisée en ce que** le dispositif de commande pour la commande de la source est conçu pour émettre des impulsions espacées dans le temps avec une durée de longueur D et une pause de longueur P entre les impulsions, sachant que, pour les impulsions de plasma, la pause d'impulsion P en millisecondes entre deux impulsions voisines dans le temps est supérieure à $P_{min}$ [ms] = 2,5 + 0,05 * V, de préférence $P_{min}$ [ms] = 2,5 + 0,055 * V, V désignant le volume de revêtement dans la chambre de réaction en millilitres et $P_{min}$ [ms] une durée en millisecondes.

10. Installation de revêtement selon la revendication précédente, **caractérisée en ce que** le dispositif de commande est aménagé pour commander la source, de telle sorte que la pause P entre les impulsions de plasma a une durée qui est supérieure à :

$$P_{min}[ms] = 10 + 0,133 * V,$$

$P_{min}$ [ms] désignant une durée en millisecondes et V le volume de revêtement dans la chambre de réaction en millilitres.

**11.** Installation de revêtement selon la revendication 9 ou 10, **caractérisée en ce que** le dispositif de commande est aménagé pour régler la pause entre deux impulsions de plasma plus courte que :

P[ms] = P[ms] = 80 + 0,05 * V, de préférence P[ms] = P[ms] = 60 + 0,05 * V, avec une préférence particulière pour P[ms] = P[ms] = 50 + 0,05 * V,
P[ms] désignant une durée en millisecondes et V le volume de revêtement dans la chambre de réaction en millilitres.

**12.** Installation de revêtement selon l'une des revendications 9 à 11, **caractérisée en ce que** le dispositif de commande est aménagé pour commander la source, de telle sorte que la pause P entre les impulsions de plasma ait au moins une durée qui est donnée par :

$$P[ms] = max(2,5 + 0,05 * V, V \cdot [(1/6) \cdot exp(-V/300) + (1/20)]),$$

$P_{min}$ [ms] désignant une durée en millisecondes et V le volume de revêtement dans la chambre de réaction en millilitres.

**13.** Installation de revêtement selon l'une des revendications précédentes, **caractérisée en ce que** la dérivation vers la chambre de réaction comprend une conduite de contournement (33), qui est agencée avec plusieurs déviations vers la chambre de réaction et/ou comprend des obstacles dans la dérivation, qui entraînent des tourbillonnements du flux de gaz, de sorte qu'un mélange turbulent des gaz mis en contact les uns avec les autres au point de mélange de gaz intervient.

**14.** Installation de revêtement selon l'une des revendications précédentes, **caractérisée par** :

plusieurs chambres de réaction, dans lesquelles des objets à revêtir peuvent être disposés, ou des dispositifs pour former des chambres de réaction avec des objets à revêtir, un dispositif d'arrivée de gaz avec une dérivation vers les chambres de réaction et un dispositif pour le rayonnement d'énergie électromagnétique, afin d'allumer un plasma dans la zone remplie par le gaz de procédé dans les chambres de réaction, la dérivation étant divisée en plusieurs embranchements (38-41), qui sont raccordés à chaque fois à une chambre de réaction, à chaque fois exactement deux embranchements partant d'une conduite du système de conduite avec la dérivation du système d'arrivée de gaz et les embranchements d'une conduite, de sorte que la dérivation est divisée en $2^n$, n = 2, 3, ..., conduites d'embranchement et les arrivées à chaque chambre sont souvent divisées de la même façon.

**15.** Installation de revêtement selon la revendication 14, **caractérisée en ce que** les conduites d'embranchement dévient dans un plan partant de la dérivation.

**16.** Installation de revêtement selon la revendication précédente, l'installation de revêtement étant **caractérisée en ce qu'**elle présente plusieurs points de mélange de gaz, qui sont disposés le long d'une direction transversalement au plan, dans lequel les conduites d'embranchement se situent.

**17.** Installation de revêtement selon l'une des revendications précédentes, **caractérisée par** un dispositif de spectromètre (64) pour l'enregistrement avec résolution dans le temps de lignes d'émission et/ou de spectres, qui se forment lors du revêtement à l'intérieur de la chambre de réaction.

**18.** Installation de revêtement selon l'une des revendications précédentes, **caractérisée par** un dispositif pour l'enregistrement des formes de train d'impulsions de gaz précurseurs, en particulier pour la mesure de leurs courbes de densité dans le temps et de leurs vitesses.

**19.** Installation de revêtement selon la revendication précédente, **caractérisée en ce que** le dispositif pour l'enregistrement des formes de train d'impulsions de gaz précurseurs comprend un dispositif de spectromètre optique pour l'enregistrement de lignes de fluorescence et/ou de lignes d'absorption.

**EP 1 921 179 B1**

**20.** Procédé pour le revêtement d'objets avec des couches alternées dans une installation de revêtement, en particulier dans une installation de revêtement selon l'une des revendications précédentes, de préférence pour le revêtement simultané de plusieurs objets avec des couches alternées, un objet à revêtir étant disposé dans au moins une chambre de réaction ou une chambre de réaction étant formée avec un objet à revêtir, au moins une zone de revêtement de la chambre de réaction étant mise sous vide, et ensuite différents gaz de procédé étant introduits dans la zone de revêtement et un plasma pulsé étant allumé au moyen d'une source, exploitée de façon pulsée, d'énergie électromagnétique pour la séparation, de sorte qu'un système de couches avec des niveaux de composition différente est déposé sur l'objet, l'introduction des gaz de procédé dans la chambre de réaction s'effectuant au moyen d'un dispositif de remplacement de gaz, le dispositif de remplacement de gaz comprenant au moins un point de mélange de gaz, dans lequel débouchent au moins deux conduites d'arrivée dotées de soupapes pour différents gaz précurseurs, et au moins une conduite d'arrivée pour un autre gaz, cet autre gaz étant mélangé au point de mélange de gaz avec respectivement l'un des gaz introduits par l'une des soupapes et étant évacué par une dérivation vers la chambre de réaction, l'arrivée pour un autre gaz et la dérivation vers la chambre de réaction étant raccordées dans la liaison entre les deux soupapes, et à chaque fois une conduite de by-pass reliée à un dispositif de pompage étant prévue pour chacune des conduites d'arrivée pour différents gaz précurseurs, à chaque fois une autre soupape étant branchée sur les conduites de by-pass, et le mélange de gaz de procédé étant remplacé du fait que les soupapes dans les conduites de by-pass et les soupapes des conduites d'arrivée pour différents gaz précurseurs sont commandées de telle sorte qu'en même temps la soupape est fermée dans la conduite d'arrivée d'un gaz précurseur, la soupape dans la conduite de by-pass est ouverte pour ce gaz précurseur et inversement la soupape dans la conduite d'arrivée de l'autre gaz précurseur est ouverte et la soupape dans la conduite de by-pass est fermée simultanément pour ce gaz précurseur, à chaque fois un niveau de la couche alternée étant séparé au moyen d'une série d'impulsions d'impulsions de plasma, réglant le moment du début d'une série d'impulsions pour la séparation d'un niveau du système de couches alternées en fonction du temps de commutation des soupapes, et une pause avec une durée d'au moins $0{,}8 \times | t_{Vorlauf} - t_{Nachlauf} |$ et d'au maximum $5 \times | t_{Vorlauf} - t_{Nachlauf} |$ étant réglée entre les séries d'impulsions pour la séparation de niveaux successifs, $t_{Vorlauf}$ désignant le temps que met le gaz pour arriver du point de mélange de gaz à la chambre de réaction et $t_{Nachlauf}$ désignant le temps qui est nécessaire pour le vidage du mélange de gaz de procédé se trouvant auparavant dans la chambre de réaction.

**21.** Procédé selon la revendication précédente, **caractérisé en ce que** la source est commandée de telle sorte qu'une série d'impulsions destinée à séparer un niveau du système de couches alternées est démarrée à chaque fois à un moment qui est retardé d'une durée T par rapport au moment de commutation des soupapes attribuées pour le mélange respectif de gaz de procédé pour la séparation d'un niveau du système de couches alternées dans l'arrivée, la durée T étant au moins $0{,}8 \times t_{Vorlauf}$ et au maximum $50 \times t_{Vorlauf}$.

**22.** Procédé selon l'une des deux revendications précédentes, **caractérisé en ce que** la pression dans les conduites de dérivation est adaptée à la pression au point de mélange de gaz au moyen d'un dispositif de réglage.

**23.** Procédé selon la revendication précédente, **caractérisé en ce que** la pression dans les conduites de by-pass est adaptée à la pression au point de mélange de gaz pour une différence de pression qui est inférieure à 20 % de la pression au point de mélange de gaz.

**24.** Procédé selon l'une des revendications 20 à 23, **caractérisé en ce que** les gaz sont mélangés dans une unité de soupape de point de mélange, sur laquelle les sièges des deux soupapes sont regroupés dans un bloc de soupapes commun.

**25.** Procédé selon l'une des revendications 20 à 24, **caractérisé en ce que**, au point de mélange, de l'azote est mélangé avec au moins un précurseur.

**26.** Procédé selon l'une des revendications 20 à 25, **caractérisé en ce qu'**un dispositif de commande commande la source, de telle sorte que les impulsions de plasma dans la chambre de réaction présentant une durée de longueur D et une pause de longueur P sont générées entre les impulsions, sachant que, pour les impulsions de plasma, la pause d'impulsion P en millisecondes entre deux impulsions voisines dans le temps est plus longue que :

$P_{min}$ [ms] = 2,5 + 0,05 * V, de préférence $P_{min}$[ms] = 2,5 + 0,055 * V,
V désignant le volume de revêtement dans la chambre de réaction en millilitres et $P_{min}$[ms] une durée en millisecondes.

**27.** Procédé selon la revendication précédente, **caractérisé en ce que** la pause P est réglée plus longue que :

$$P[ms] = 10 + 0,133 * V,$$

P[ms] désignant une durée en millisecondes et V le volume de revêtement dans la chambre de réaction en millilitres.

28. Procédé selon la revendication 26 ou 27, **caractérisé en ce que** la pause P entre deux impulsions voisines dans le temps est réglée plus longue que :

$$P[ms] = \max(2,5 + 0,05 * V, V \cdot [(1/6) \cdot \exp(-V/300) + (1/20)]),$$

$P_{min}[ms]$ désignant une durée en millisecondes et V le volume de revêtement dans la chambre de réaction en millilitres.

29. Procédé selon l'une des revendications 26 à 28, **caractérisé en ce que** la pause est réglée plus courte que P[ms] = 80 + 0,05 * V, de préférence P[ms] = 60 +0,05 * V, avec une préférence particulière pour P[ms] = 50 + 0,05 * V, P[ms] désignant une durée en millisecondes et V le volume de revêtement dans la chambre de réaction en millilitres.

30. Procédé selon l'une des revendications 20 à 29 **caractérisé en ce que** les gaz mis en contact les uns avec les autres au point de mélange sont déviés par une conduite de contournement vers la chambre de réaction, laquelle conduite de contournement est agencée avec plusieurs déviations vers la chambre, de réaction et/ou comprend des obstacles dans la dérivation, le flux de gaz des gaz mis en contact les uns avec les autres au point de mélange des gaz étant mis en tourbillon dans là conduite de contournement sur les déviations et/ou sur les obstacles de sorte qu'un tourbillonnement turbulent des gaz intervient.

31. Procédé selon l'une des revendications 20 à 30 **caractérisé en ce que** plusieurs objets à revêtir sont disposés dans plusieurs chambres de réaction ou des chambres de réaction sont formées avec des objets à revêtir, au moins les zones de revêtement des chambres de réaction étant mises sous vide et du gaz de procédé étant acheminé dans les zones de revêtement et un plasma étant allumé pour la séparation, de sorte qu'un revêtement est séparé, l'introduction des gaz de procédé dans les chambres de réaction s'effectuant au moyen d'une dérivation partant d'un point de mélange de gaz, différents gaz du gaz de procédé étant mélangés au point de mélange et le flux de gaz étant divisé par la dérivation en $2^n$, n = 2, 3, ..., embranchements en autant de flux partiels, lesquels sont guidés à chaque fois dans une chambre de réaction, chaque flux partiel étant divisé en même temps souvent à la sortie du flux partiel et le flux partiel étant divisé en exactement deux flux partiels lors de chaque division.

32. Procédé selon la revendication 31, **caractérisé en ce que** les flux partiels sont divisés à la sortie dans un embranchement partant de la dérivation.

Fig. 1

EP 1 921 179 B1

Fig. 2

Fig. 3

28

Fig. 4

V · [(1/6) · exp(-V/300) + 1/20]

Fig. 5

V · [(1/6) · exp(-V/300) + 1/20]

Fig. 6

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0519215 B1